# EUROPEAN PATENT APPLICATION

(11) **EP 4 561 316 A1**
(43) Date of publication of application: **28.05.2025**
(21) Application number: 24214487.1
(22) Date of filing: 21.11.2024
(51) Int. Cl.: H10K 59/122, H10K 59/123, H10K 59/80, H10K 59/131

(54) **DISPLAY PANEL AND METHOD OF MANUFACTURING THE SAME**

(30) Priority: 22.11.2023 KR 20230162965
(71) Applicant: Samsung Display Co., Ltd., Yongin-si, Gyeonggi-do (KR)
(72) Inventor: KIM, Sunho, Yongin-si (KR); KO, Yoomin, Yongin-si (KR); PARK, Juchan, Yongin-si (KR); SON, Yerim, Yongin-si (KR); CHOI, Chung Sock, Yongin-si (KR)
(74) Representative: Marks & Clerk LLP

(57) **Abstract**

A display panel includes a driving element layer including a pixel driving part, a light emitting element disposed on the driving element layer and including a first electrode, an intermediate layer disposed on the first electrode, and a second electrode disposed on the intermediate layer. The display panel further includes a pixel definition layer disposed on the driving element layer and including a light emitting opening to expose at least a portion of the first electrode and a groove to surround the light emitting opening, and a connection electrode disposed on the pixel definition layer and electrically connected to the pixel driving part and the second electrode.

## Description

### BACKGROUND

### 1. Technical Field

This disclosure relates to a display panel with improved contact reliability and a method of manufacturing the display panel.

### 2. Description of Related Art

Multimedia electronic devices, such as televisions, mobile phones, tablet computers, navigation devices, and game devices, include a display panel to display an image. The display panel includes light emitting elements and a circuit to drive the light emitting element. The light emitting elements included in the display panel emit a light in response to a voltage applied thereto by the circuit and generate the image. Research regarding connections between the light emitting elements and the circuit are in progress to improve a reliability of the display panel.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

This disclosure provides a display panel with improved contact reliability.

This disclosure provides a method of manufacturing the display panel with improved contact reliability.

Embodiments of the disclosure provide a display panel that includes a driving element layer including a pixel driving part, a light emitting element disposed on the driving element layer and including a first electrode, an intermediate layer disposed on the first electrode, and a second electrode disposed on the intermediate layer, a pixel definition layer disposed on the driving element layer and including a light emitting opening to expose at least a portion of the first electrode and a groove to surround the light emitting opening, and a connection electrode disposed on the pixel definition layer and electrically connected to the pixel driving part and the second electrode.

The light emitting element may include a plurality of light emitting elements, the pixel driving part may include a plurality of pixel driving parts, and the connection electrode may include a plurality of connection electrodes. The plurality of connection electrodes may electrically connect the plurality of light emitting elements and the plurality of pixel driving parts. gap A gap between the plurality of connection electrodes adjacent to each other may overlap the groove.

The connection electrode may include a first edge, and a second edge surrounding the first edge, and the second edge may overlap the groove.

The second electrode may be electrically connected to the connection electrode in an area adjacent to the groove.

The connection electrode may include a tip portion that protrudes from an end of the groove, and the connection electrode may overlap the groove of the pixel definition layer in plan view.

The second electrode may be electrically connected to the connection electrode at the tip portion.

A through hole may be further defined through the pixel definition layer, and the connection electrode may be electrically connected to the pixel driving part through the through hole.

The connection electrode may include a first connection electrode layer disposed on the pixel definition layer, and a second connection electrode layer disposed on the first connection electrode layer, and the second connection electrode layer may overlap the first connection electrode layer.

The intermediate layer may be disposed on the second connection electrode layer, the second electrode may be disposed on the intermediate layer, and the second electrode may be electrically connected to the second connection electrode layer at the tip portion.

The display panel may further include a first partition pattern, a second partition pattern, and a third partition pattern. The first partition pattern and the second connection electrode layer may include a same material, the second partition pattern and the intermediate layer may include a same material, and the third partition pattern and the second electrode may include a same material. The first, second, and third partition patterns may be disposed in the groove.

The first partition pattern may be electrically connected to the third partition pattern.

The connection electrode may include a first connection electrode layer disposed on the pixel definition layer, and the intermediate layer may overlap the first connection electrode layer.

The display panel may further include a first partition pattern, and a second partition pattern. The first partition pattern and the intermediate layer may include a same material, and the second partition pattern and the second electrode may include a same material. The first and second partition patterns may be disposed in the groove.

The pixel definition layer may include a first pixel definition layer portion, and a second pixel definition layer portion disposed on the first pixel definition layer portion, the first pixel definition layer portion may be integral with the second pixel definition layer portion, and the groove may be defined in the second pixel definition layer portion.

Embodiments of the disclosure provide a display panel that may include a driving element layer including a pixel driving part, a light emitting element disposed on the driving element layer and including a first electrode, an intermediate layer disposed on the first electrode, and a second electrode disposed on the intermediate layer. The display panel may further include a pixel definition layer disposed on the driving element layer and including a groove which may be formed by removing a portion of the pixel definition layer in a thickness direction thereof, and a connection electrode disposed on the pixel definition layer and including a tip portion that protrudes from an end of the groove.

The pixel definition layer may further include a light emitting opening to expose at least a portion of the first electrode, and the groove may surround the light emitting opening.

The connection electrode may electrically connect the pixel driving part and the second electrode, and the second electrode may be electrically connected to the connection electrode at the tip portion.

A through hole may be defined through the pixel definition layer, and the connection electrode may be electrically connected to the pixel driving part through the through hole.

The light emitting element may include a plurality of light emitting elements, the pixel driving part may include a plurality of pixel driving parts, and the connection electrode may include a plurality of connection electrodes. The plurality of connection electrodes may electrically connect the plurality of light emitting elements and the plurality of pixel driving parts. A gap between the plurality of connection electrodes adjacent to each other may overlap the groove.

The connection electrode may include a first edge, and a second edge surrounding the first edge, and the second edge may overlap the groove.

The connection electrode may include a first connection electrode layer disposed on the pixel definition layer, and a second connection electrode layer disposed on the first connection electrode layer. The second connection electrode layer may overlap the first connection electrode layer, and the second electrode may be electrically connected to the second connection electrode layer at the tip portion.

The display panel may further include a first partition pattern, a second partition pattern, and a third partition pattern. The first partition pattern and the second connection electrode may include a same material, the second partition pattern and the intermediate layer may include a same material, and the third partition pattern and the second electrode may include a same material. The first, second, and third partition patterns may be disposed in the groove, and the first partition pattern may be electrically connected to the third partition pattern.

The connection electrode may include a first connection electrode layer disposed on the pixel definition layer, and the intermediate layer may overlap the first connection electrode layer.

The display panel may further include a first partition pattern, and a second partition pattern. The first partition pattern and the intermediate layer may include a same material, and the second partition pattern and the second electrode may include a same material. The first and second partition patterns may be disposed in the groove.

The pixel definition layer may include a first pixel definition layer portion, and a second pixel definition layer portion disposed on the first pixel definition layer portion. The first pixel definition layer portion may be integral with the second pixel definition layer portion, and the groove may be defined in the second pixel definition layer portion.

Embodiments of the disclosure provide a method of manufacturing a display panel. The method includes preparing a preliminary display panel including a base layer, a driving element layer disposed on the base layer, and a pixel definition layer disposed on the driving element layer. The method further includes depositing a first connection electrode layer on the preliminary display panel, etching a portion of the first connection electrode layer and a portion of the pixel definition layer to form a groove overlapping the first connection electrode layer in the pixel definition layer, etching the first connection electrode layer to form a connection electrode, and forming an intermediate layer and a cathode on the connection electrode and the pixel definition layer.

The method may further include forming a tip portion at an end of the first connection electrode layer.

The method may further include depositing a second connection electrode layer on the first connection electrode layer, and forming a tip portion at an end of the first connection electrode layer and an end of the second connection electrode layer. The forming of the connection electrode may include etching the second connection electrode layer.

The pixel definition layer may include a first pixel definition layer portion, and a second pixel definition layer portion disposed on the first pixel definition layer portion. The first pixel definition layer portion may be integral with the second pixel definition layer portion, and the groove may be defined in the second pixel definition layer portion.

According to the above, the light emitting element and the pixel driving part may be stably in contact with each other, and thus, the contact reliability between the light emitting element and the pixel driving part may be improved. As an example, as the connection electrode may be electrically connected to the cathode of the light emitting element and the pixel driving part at a relatively wide area instead of a specific point, the contact reliability may be enhanced. Accordingly, external defects, e.g., spots detected during illumination, caused by a contact defect may be reduced or eliminated. Thus, the display quality and the manufacturing yield of the display panel may be improved.

In addition, the lower surface of the connection electrode and the upper surface of the intermediate connection electrode may be in contact with each other, and the contact reliability may be improved. Thus, a size of the through holes through which the connection electrode is connected to the intermediate connection electrode may be reduced or minimized. As a result, a size of the light emitting portion and the resolution of the display panel may be increased.

Further, the connection electrode includes the tip portion, and thus, each of the intermediate layer and the second electrode may be separated at every pixel. Accordingly, lateral leakage current may be prevented from occurring between adjacent pixels, and thus, color mixture between adjacent pixels and the brightness deterioration may be prevented.

At least some of the above and other features of the invention are set out in the claims.

### BRIEF DESCRIPTION OF THE DRAWINGS

The above and other advantages of the disclosure will become readily apparent by reference to the following detailed description when considered in conjunction with the accompanying drawings wherein:
FIG. 1 is a schematic block diagram of a display device according to an embodiment of the disclosure;
FIGS. 2A to 2C are schematic diagrams of equivalent circuits of pixels according to embodiments of the disclosure;
FIGS. 3A and 3B are schematic plan views of display panels according to embodiments of the disclosure;
FIGS. 4A to 4D are enlarged schematic plan views of some areas of a display panel according to an embodiment of the disclosure;
FIG. 5 is a schematic cross-sectional view of a display panel according to an embodiment of the disclosure;
FIG. 6A is an enlarged schematic cross-sectional view of an area of a display panel according to an embodiment of the disclosure;
FIG. 6B is an enlarged schematic plan view of an area of a display panel according to an embodiment of the disclosure;
FIG. 6C is an enlarged schematic cross-sectional view of an area of a display panel according to an embodiment of the disclosure;
FIG. 7 is an enlarged schematic cross-sectional view of an area of a display panel according to an embodiment of the disclosure;
FIG. 8 is an enlarged schematic cross-sectional view of an area of a display panel according to an embodiment of the disclosure;
FIG. 9 is an enlarged schematic cross-sectional view of an area of a display panel according to an embodiment of the disclosure;
FIGS. 10Ato 10F are schematic cross-sectional views illustrating processes of a method of manufacturing a display panel according to an embodiment of the disclosure;
FIGS. 11A to 11C are schematic cross-sectional views illustrating processes of a method of manufacturing a display panel according to an embodiment of the disclosure;
FIGS. 12A to 12F are schematic cross-sectional views illustrating processes of a method of manufacturing a display panel according to an embodiment of the disclosure; and
FIGS. 13A to 13C are schematic cross-sectional views illustrating processes of a method of manufacturing a display panel according to an embodiment of the disclosure.

### DETAILED DESCRIPTION OF THE EMBODIMENTS

The disclosure will now be described more fully hereinafter with reference to the accompanying drawings, in which embodiments are shown. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

In the disclosure, it will be understood that when an element (or area, layer, or portion) is referred to as being "on", "connected to" or "coupled to" another element or layer, it can be directly on, connected or coupled to the other element or layer or intervening elements or layers may be present.

Like numerals refer to like elements throughout. In the drawings, the thickness, ratio, and dimension of components may be exaggerated for effective description of the technical content. As used herein, the term "and/or" may include any and all combinations of one or more of the associated listed items. For example, "A and/or B" may be understood to mean "A, B, or A and B." The terms "and" and "or" may be used in the conjunctive or disjunctive sense and may be understood to be equivalent to "and/or."

In the specification and the claims, the phrase "at least one of"' is intended to include the meaning of "at least one selected from the group of" for the purpose of its meaning and interpretation. For example, "at least one of A and B" may be understood to mean "A, B, or A and B."

It will be understood that, although the terms "first," "second," etc. may be used herein to describe various elements, these elements should not be limited by these terms. These terms are only used to distinguish one element from another element. Thus, a first element discussed below could be termed a second element without departing from the teachings of the disclosure. As used herein, the singular forms, "a", "an" and "the" are intended to include the plural forms as well, unless the context clearly indicates otherwise.

Spatially relative terms, such as "beneath", "below", "lower", "above", "upper" and the like, may be used herein for ease of description to describe one element or feature's relationship to another elements or features as shown in the figures.

It will be further understood that the terms "comprise," "comprising", "has," "have," "having," "include," "including," and the like, when used in this specification, specify the presence of stated features, integers, steps, operations, elements, and/or components, but do not preclude the presence or addition of one or more other features, integers, steps, operations, elements, components, and/or groups thereof.

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

Unless otherwise defined or implied, all terms including technical and scientific terms used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

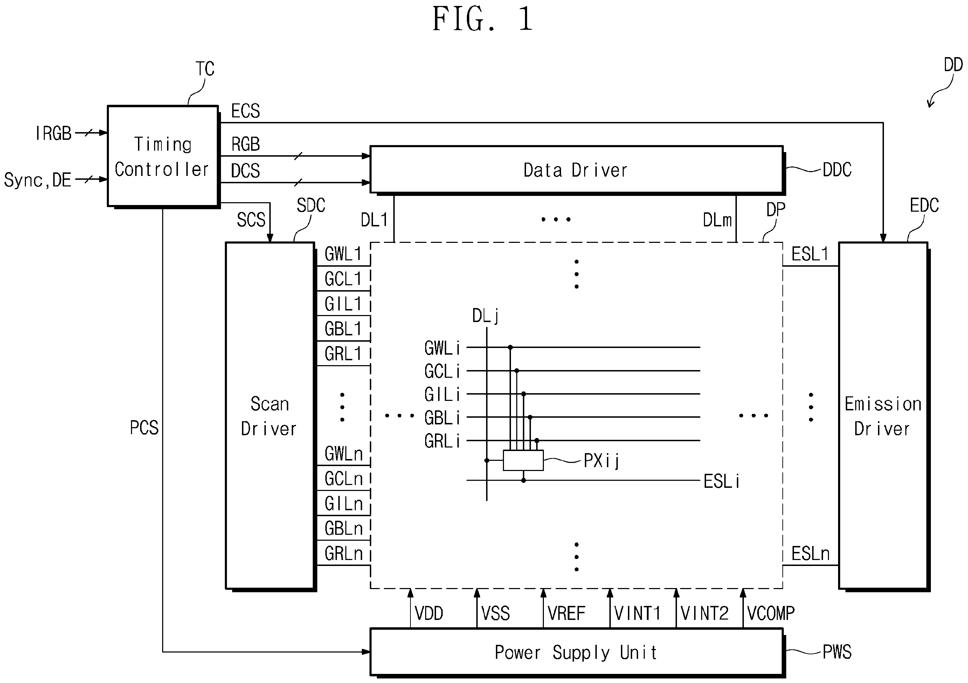

FIG. 1 is a schematic block diagram of a display device DD according to an embodiment of the disclosure.

Referring to FIG. 1, the display device DD may include a display panel DP, panel drivers SDC, EDC, and DDC, a power supply unit PWS, and a timing controller TC. The display panel DP may be a light-emitting type display panel. The light-emitting type display panel may be an organic light emitting display panel, an inorganic light emitting display panel, or a quantum dot light emitting display panel. Hereinafter, the organic light emitting display panel will be described as a representative example of the display panel DP The panel drivers SDC, EDC, and DDC may include a scan driver SDC, an emission driver EDC, and a data driver DDC.

The display panel DP may include scan lines GWL1 to GWLn, GCL1 to GCLn, GIL1 to GILn, GBL1 to GBLn, and GRL1 to GRLn, emission lines ESL1 to ESLn, and data lines DL1 to DLm. The display panel DP may include pixels connected to the scan lines GWL1 to GWLn, GCL1 to GCLn, GIL1 to GILn, GBL1 to GBLn, and GRL1 to GRLn, the emission lines ESL1 to ESLn, and the data lines DL1 to DLm. Each of "m" and "n" is an integer number greater than 1.

As an example, a pixel PXij (each of "i" and "j" is an integer number greater than 1) positioned to correspond to an i-th horizontal line (or an i-th pixel row) and a j-th vertical line (or a j-th pixel column) may be connected to an i-th first scan line (or a write scan line) GWLi, an i-th second scan line (or a compensation scan line) GCLi, an i-th third scan line (or a first initialization scan line) GILi, an i-th fourth scan line (or a second initialization scan line) GBLi, an i-th fifth scan line (or a reset scan line) GRLi, a j-th data line DLj, and an i-th emission line ESLi.

The pixel PXij may include light emitting elements, transistors, and capacitors. The pixel PXij may receive a first power voltage VDD, a second power voltage VSS, a third power voltage (or a reference voltage) VREF, a fourth power voltage (or a first initialization voltage) VINT1, a fifth power voltage (or a second initialization voltage) VINT2, and a sixth power voltage (or a compensation voltage) VCOMP from the power supply unit PWS.

The first power voltage VDD and the second power voltage VSS may have a voltage value set to allow a current to flow through the light emitting element, and thus a light may be emitted from the light emitting element. As an example, the first power voltage VDD may be set to have a voltage level higher than that of the second power voltage VSS.

The third power voltage VREF may be a voltage to initialize a gate of a driving transistor included in the pixel PXij. The third power voltage VREF may be used to implement a predetermined or selected grayscale using a difference in voltage between the third power voltage VREF and a data signal. To this end, the third power voltage VREF may be set to a predetermined or selected voltage in a voltage range of the data signal.

The fourth power voltage VINT1 may be used to initialize the capacitor included in the pixel PXij. The fourth power voltage VINT1 may be set to a voltage level lower than that of the third power voltage VREF. As an example, the fourth power voltage VINT1 may be set to a voltage level lower than a difference between the third power voltage VREF and a threshold voltage of the driving transistor, however, the disclosure should not be limited thereto or thereby.

The fifth power voltage VINT2 may be used to initialize a cathode of the light emitting element included in the pixel PXij. The fifth power voltage VINT2 may be set to a voltage level lower than the first power voltage VDD or the fourth power voltage VINT1 or may be set to a voltage level similar to or the same as the third power voltage VREF, however, embodiments should not be limited thereto or thereby. The fifth power voltage VINT2 may be set to a voltage level similar to or the same as the first power voltage VDD.

The sixth power voltage VCOMP may provide a predetermined or selected current to the driving transistor in case that the threshold voltage of the driving transistor is compensated for.

FIG. 1 shows a structure in which all the first, second, third, fourth, fifth, and sixth power voltages VDD, VSS, VREF, VINT1, VINT2, and VCOMP are provided from the power supply unit PWS, however, the disclosure should not be limited thereto or thereby. As an example, both of the first power voltage VDD and the second power voltage VSS may be provided regardless of the structure of the pixel PXij, and at least one of the third power voltage VREF, the fourth power voltage VINT1, the fifth power voltage VINT2, and the sixth power voltage VCOMP need not be provided according to the structure of the pixel PXij.

According to the disclosure, signal lines connected to the pixel PXij may be designed in various ways by taking into account the structure of the pixel PXij.

The scan driver SDC may receive a first control signal SCS from the timing controller TC and may provide a scan signal to the first scan lines GWL1 to GWLn, the second scan lines GCL1 to GCLn, the third scan lines GIL1 to GILn, the fourth scan lines GBL1 to GBLn, and the fifth scan lines GRL1 to GRLn in response to the first control signal SCS.

The scan signal may be set to a voltage that allows the transistors to be turned on in response to the scan signal. As an example, the scan signal provided to a P-type transistor may be set to a logic low level, and the scan signal provided to an N-type transistor may be set to a logic high level. Hereinafter, the expression "the scan signal is provided." may mean that the scan signal is provided to the transistor, which is controlled thereby, with a logic level that turns on the transistor.

For the convenience of explanation, FIG. 1 shows one scan driver SDC, however, the disclosure should not be limited thereto or thereby. According to an embodiment, the display device DD may include multiple scan drivers to provide the scan signal to the first scan lines GWL1 to GWLn, the second scan lines GCL1 to GCLn, the third scan lines GIL1 to GILn, the fourth scan lines GBL1 to GBLn, and the fifth scan lines GRL1 to GRLn.

The emission driver EDC may provide emission signals to the emission lines ESL1 to ESLn in response to a second control signal ECS. As an example, the emission signals may be sequentially provided to the emission lines ESL1 to ESLn.

Each transistor connected to the emission lines ESL1 to ESLn may be the N-type transistor. The emission signals provided to the emission lines ESL1 to ESLn may have a gate-off voltage. The transistors receiving the emission signal may be turned off in case receiving the emission signal and may be turned on in other cases.

The second control signal ECS may include an emission start signal and clock signals, and the emission driver EDC may be implemented by a shift register that sequentially shifts the emission start signal with a pulse shape using the clock signals to sequentially generate and output the emission signal with a pulse shape.

The data driver DDC may receive a third control signal DCS and image data RGB from the timing controller TC. The data driver DDC may convert the image data RGB in a digital form to analog data signals. The data driver DDC may provide the data signal to the data lines DL1 to DLm in response to the third control signal DCS.

The third control signal DCS may include a data enable signal, a horizontal start signal, and a data clock signal to indicate an output of an effective data signal. As an example, the data driver DDC may include a shift register that shifts the horizontal start signal in synchronization with the data clock signal to generate a sampling signal, a latch that latches the image data RGB in response to the sampling signal, a digital-analog converter (or a decoder) that converts the latched image data, e.g., data in the digital form, to data signals in the analog form, and buffers (or amplifiers) that output the data signals to the data lines DL1 to DLm.

The power supply unit PWS may provide the first power voltage VDD, the second power voltage VSS, and the third power voltage VREF to the display panel DP to drive the pixel PXij. In addition, the power supply unit PWS may provide at least one voltage of the fourth power voltage VINT1, the fifth power voltage VINT2, and the sixth power voltage VCOMP to the display panel DP.

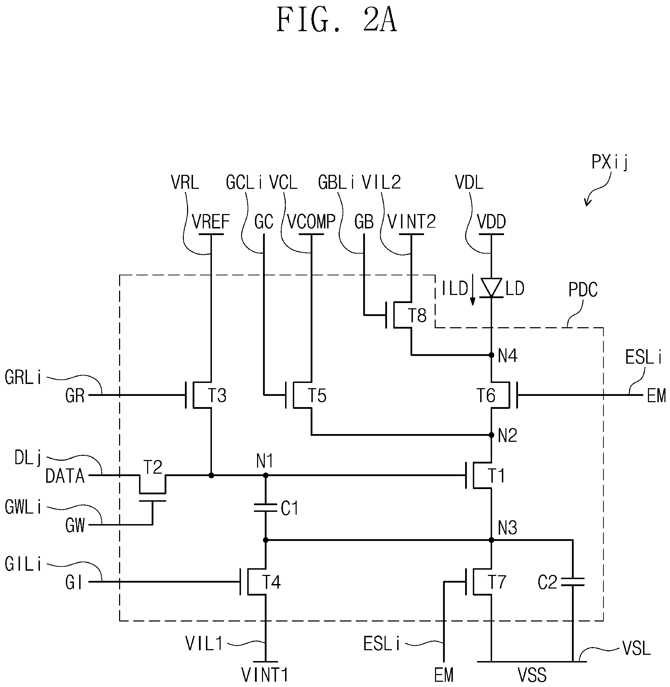

As an example, the power supply unit PWS may provide the first power voltage VDD, the second power voltage VSS, the third power voltage VREF, the fourth power voltage VINT1, the fifth power voltage VINT2, and the sixth power voltage VCOMP to the display panel DP respectively via a first power line VDL (refer to FIG. 2A), a second power line VSL (refer to FIG. 2A), a third power line (or a reference voltage line) VRL (refer to FIG. 2A), a fourth power line (or a first initialization voltage line) VIL1 (refer to FIG. 2A), a fifth power line (or a second initialization voltage line) VIL2 (refer to FIG. 2A), and a sixth power line (or a compensation voltage line) VCL (refer to FIG. 2A), which are not shown in FIG. 1.

The power supply unit PWS may be implemented by a power management IC, however, the disclosure should not be limited thereto or thereby.

The timing controller TC may generate the first control signal SCS, the second control signal ECS, the third control signal DCS, and a fourth control signal PCS based on input image data IRGB, a synchronization signal Sync, e.g., a vertical synchronization signal, a horizontal synchronization signal, etc., the data enable signal DE, and a clock signal. The first control signal SCS may be applied to the scan driver SDC, the second control signal ECS may be applied to the emission driver EDC, the third control signal DCS may be applied to the data driver DDC, and the fourth control signal PCS may be applied to the power supply unit PWS. The timing controller TC may rearrange the input image data IRGB to correspond to an arrangement of the pixel PXij in the display panel DP and may generate the image data RGB (or frame data).

The scan driver SDC, the emission driver EDC, the data driver DDC, the power supply unit PWS, and/or the timing controller TC may be directly formed in the display panel DP or may be connected to the display panel DP after being manufactured in a separate driving chip. In addition, at least two of the scan driver SDC, the emission driver EDC, the data driver DDC, the power supply unit PWS, and the timing controller TC may be provided in a single driving chip. As an example, the data driver DDC and the timing controller TC may be provided in a single driving chip.

Although the display device DD according to an embodiment is described with reference to FIG. 1 in the above descriptions, the display device DD of the disclosure should not be limited thereto or thereby. Signal lines may be added or omitted depending on the structure of the pixels. In addition, a connection relationship between one pixel and the signal lines may be changed. In a case where one of the signal lines is omitted, the omitted signal line may be replaced with another signal line.

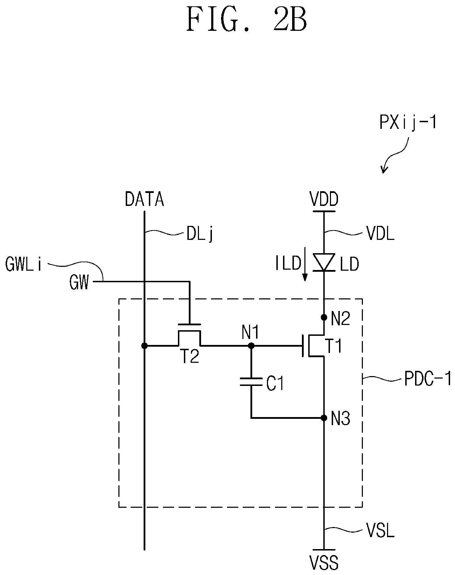

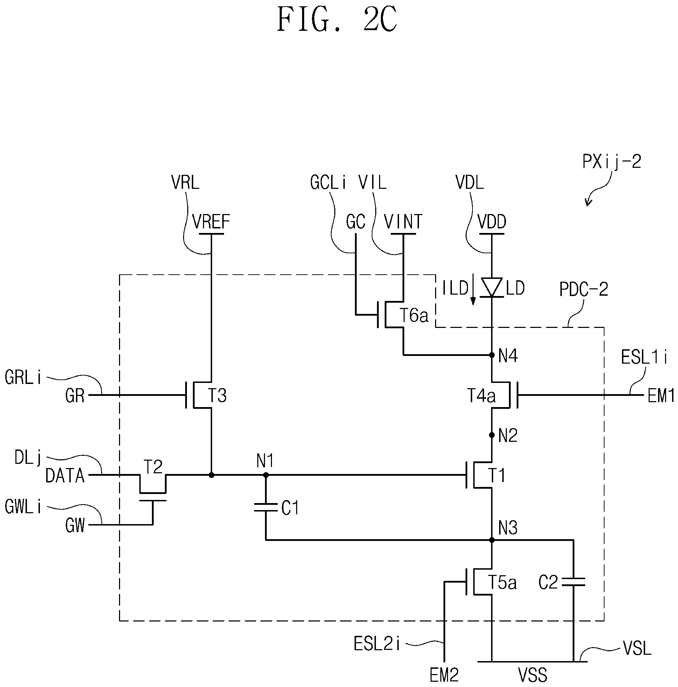

FIGS. 2A, 2B, and 2C are schematic diagrams of equivalent circuits of pixels according to embodiments of the disclosure. FIGS. 2A, 2B, and 2C show the equivalent circuit diagrams of pixels PXij, PXij-1, and PXij-2, which are connected to the i-th first scan line GWLi (hereinafter, referred to as write scan line GWLi) and the j-th data line DLj (hereinafter, referred to as a data line DLj).

Referring to FIG. 2A, the pixel PXij may include a light emitting element LD and a pixel driving unit (part) PDC. The light emitting element LD may be connected to the first power line VDL and the pixel driving unit PDC.

The pixel driving unit PDC may be connected to the scan lines GWLi, GCLi, GILi, GBLi, and GRLi, the data line DLj, the emission line ESLi, and the power lines VDL, VSL, VIL1, VIL2, VRL, and VCL. The pixel driving unit PDC may include first, second, third, fourth, fifth, sixth, seventh, and eighth transistors T1, T2, T3, T4, T5, T6, T7, and T8, a first capacitor C1, and a second capacitor C2. Hereinafter, each of the first, second, third, fourth, fifth, sixth, seventh, and eighth transistors T1, T2, T3, T4, T5, T6, T7, and T8 will be described as the N-type transistor, however, the disclosure should not be limited thereto or thereby. According to an embodiment, some of the first to eighth transistors T1 to T8 may be the N-type transistor, and the other of the first to eighth transistors T1 to T8 may be the P-type transistor, or each of the first to eighth transistors T1 to T8 may be the P-type transistor, and the disclosure should not be particularly limited.

A gate of the first transistor T1 may be connected to a first node N1. A first electrode of the first transistor T1 may be connected to a second node N2, and a second electrode of the first transistor T1 may be connected to a third node N3. The first transistor T1 may be a driving transistor. The first transistor T1 may control a driving current ILD flowing from the first power line VDL to the second power line VSL via the light emitting element LD in response to a voltage of the first node N1. The first power voltage VDD may be set to a voltage with an electric potential higher than the second power voltage VSS.

In the disclosure, the expression "a transistor is connected to a signal line" means that one electrode of a source electrode, a drain electrode, and a gate electrode of the transistor is provided integrally with the signal line or connected to the signal line via a connection electrode. In addition, the expression "a transistor is electrically connected to another transistor" means that one electrode of a source electrode, a drain electrode, and a gate electrode of the transistor is provided integrally with one electrode of a source electrode, a drain electrode, a gate electrode of another transistor or connected to one electrode of the source electrode, the drain electrode, the gate electrode of another transistor via a connection electrode.

The second transistor T2 may include a gate connected to the write scan line GWLi, a first electrode connected to the data line DLj, and a second electrode connected to the first node N1. The second transistor T2 may provide a data signal DATA to the first node N1 in response to a write scan signal GW applied thereto via the write scan line GWLi. The second transistor T2 may be turned on in case that the write scan signal GW is applied thereto via the write scan line GWLi, and thus, the data line DLj may be electrically connected to the first node N1.

The third transistor T3 may be connected between the first node N1 and the reference voltage line VRL. A first electrode of the third transistor T3 may receive the reference voltage VREF via the reference voltage line VRL, and a second electrode of the third transistor T3 may be connected to the first node N1. In an embodiment, a gate of the third transistor T3 may receive a reset scan signal GR via the i-th fifth scan line GRLi (hereinafter, referred to as a reset scan line). The third transistor T3 may be turned on in case that the reset scan signal GR is applied thereto via the reset scan line GRLi and may provide the reference voltage VREF to the first node N1.

The fourth transistor T4 may be connected between the third node N3 and the first initialization voltage line VIL1. A first electrode of the fourth transistor T4 may be connected to the third node N3, and a second electrode of the fourth transistor T4 may be connected to the first initialization voltage line VIL1 through which the first initialization voltage VINT1 is provided. The fourth transistor T4 may be referred to as a first initialization transistor. A gate of the fourth transistor T4 may receive a first initialization scan signal GI via the i-th third scan line GILi (hereinafter, referred to as a first initialization scan line). The fourth transistor T4 may be turned on in case that the first initialization scan signal GI is provided thereto via the first initialization scan line GILi and may provide the first initialization voltage VINT1 to the third node N3.

The fifth transistor T5 may be connected between the compensation voltage line VCL and the second node N2. A first electrode of the fifth transistor T5 may receive the compensation voltage VCOMP via the compensation voltage line VCL, and a second electrode of the fifth transistor T5 may be connected to the second node N2 to be electrically connected to the first electrode of the first transistor T1. A gate of the fifth transistor T5 may receive a compensation scan signal GC via the i-th second scan line GCLi (hereinafter, referred to as a compensation scan line). The fifth transistor T5 may be turned on in case that the compensation scan signal GC is provided thereto via the compensation scan line GCLi and may provide the compensation voltage VCOMP to the second node N2, and thus, the threshold voltage of the first transistor T1 may be compensated for during a compensation period.

The sixth transistor T6 may be connected between the first transistor T1 and the light emitting element LD. In detail, a gate of the sixth transistor T6 may receive an emission signal EM via the i-th emission line ESLi (hereinafter, referred to as an emission line). A first electrode of the sixth transistor T6 may be connected to the cathode of the light emitting element LD via a fourth node N4, and a second electrode of the sixth transistor T6 may be connected to the first electrode of the first transistor T1 via the second node N2. The sixth transistor T6 may be referred to as a first emission control transistor. The sixth transistor T6 may be turned on in case that the emission signal EM is provided thereto via the emission line ESLi, and thus, the light emitting element LD may be electrically connected to the first transistor T1.

The seventh transistor T7 may be connected between the second power line VSL and the third node N3. A first electrode of the seventh transistor T7 may be connected to the second electrode of the first transistor T1 via the third node N3, and a second electrode of the seventh transistor T7 may receive the second power voltage VSS via the second power line VSL. A gate of the seventh transistor T7 may be electrically connected to the emission line ESLi. The seventh transistor T7 may be referred to as a second emission control transistor. The seventh transistor T7 may be turned on in case that the emission signal EM is provided thereto via the emission line ESLi, and thus, the second electrode of the first transistor T1 may be electrically connected to the second power line VSL.

According to an embodiment, the sixth transistor T6 and the seventh transistor T7 may be connected to the same emission line ESLi and may be turned on in response to the same emission signal EM, however, this is merely an example. According to an embodiment, the sixth transistor T6 and the seventh transistor T7 may be independently turned on in response to different signals distinguished from each other. In addition, according to an embodiment, the sixth transistor T6 or the seventh transistor T7 may be omitted from the pixel driving unit PDC.

The eighth transistor T8 may be connected between the second initialization voltage line VIL2 and the fourth node N4. That is, the eighth transistor T8 may include a gate connected to the i-th fourth scan line GBLi (hereinafter, referred to as a second initialization scan line), a first electrode connected to the second initialization voltage line VIL2, and a second electrode connected to the fourth node N4. The eighth transistor T8 may be referred to as a second initialization transistor. The eighth transistor T8 may provide the second initialization voltage VINT2 to the fourth node N4 corresponding to the cathode of the light emitting element LD in response to a second initialization scan signal GB applied thereto via the second initialization scan line GBLi. The cathode of the light emitting element LD may be initialized by the second initialization voltage VINT2.

According to an embodiment, some of the second, third, fourth, fifth, sixth, seventh, and eighth transistors T2, T3, T4, T5, T6, T7, and T8 may be substantially simultaneously turned on in response to the same scan signal. As an example, the eighth transistor T8 and the fifth transistor T5 may be substantially simultaneously turned on in response to the same scan signal. As an example, the eighth transistor T8 and the fifth transistor T5 may be operated in response to the same compensation scan signal GC. The eighth transistor T8 and the fifth transistor T5 may be substantially simultaneously turned on and off in response to the same compensation scan signal GC. The compensation scan line GCLi and the second initialization scan line GBLi may be substantially provided as a single scan line. Accordingly, the initialization of the cathode of the light emitting element LD and the compensation of the threshold voltage of the first transistor T1 may be performed at the same timing. However, the disclosure should not be limited thereto or thereby.

In addition, according to the disclosure, the initialization of the cathode of the light emitting element LD and the compensation of the threshold voltage of the first transistor T1 may be performed in response to the same power voltage. As an example, the compensation voltage line VCL and the second initialization voltage line VIL2 may be substantially provided as a single power line. The initialization operation of the cathode and the compensation operation of the driving transistor may be performed using one power voltage, and thus, a design for the drivers may be simplified. However, this is merely an example, and the disclosure should not be particularly limited.

The first capacitor C1 may be disposed between the first node N1 and the third node N3. The first capacitor C1 may be charged with a voltage corresponding to a difference between the voltage of the first node N1 and the voltage of the third node N3. The first capacitor C1 may be referred to as a storage capacitor.

The second capacitor C2 may be disposed between the third node N3 and the second power line VSL. That is, an electrode of the second capacitor C2 may be connected to the second power line VSL receiving the second power voltage VSS, and another electrode of the second capacitor C2 may be connected to the third node N3. The second capacitor C2 may be charged with electric charges corresponding to a difference in voltage between the second power voltage VSS and the third node N3. The second capacitor C2 may be referred to as a hold capacitor. The second capacitor C2 may have a higher storage capacity compared with the first capacitor C 1. Accordingly, the second capacitor C2 may reduce a variation in voltage of the third node N3 according to a variation in voltage of the first node N1.

In an embodiment, the light emitting element LD may be connected to the pixel driving unit PDC via the fourth node N4. The light emitting element LD may include an anode connected to the first power line VDL and the cathode opposite to the anode. In an embodiment, the light emitting element LD may be connected to the pixel driving unit PDC through the cathode thereof. That is, according to the pixel PXij, a connection node at which the light emitting element LD is connected to the pixel driving unit PDC may be the fourth node N4, and the fourth node N4 may correspond to a connection node between the first electrode of the sixth transistor T6 and the cathode of the light emitting element LD. Accordingly, an electric potential of the fourth node N4 may correspond to an electric potential of the cathode of the light emitting element LD.

In detail, the anode of the light emitting element LD may be connected to the first power line VDL, the first power voltage VDD that is a constant voltage may be applied to the anode, and the cathode may be electrically connected to the first transistor T1 via the sixth transistor T6. That is, in an embodiment in which each of the first to eighth transistors T1 to T8 is the N-type transistor, an electric potential of the third node N3 corresponding to a source of the first transistor T1 need not be directly affected by characteristics of the light emitting element LD. Accordingly, even though the characteristics of the light emitting element LD are deteriorated, an influence of the deterioration in the characteristics of the light emitting element LD on a gate-source voltage (Vgs) of the transistors constituting the pixel driving unit PDC, especially the driving transistor, may be reduced. That is, since a change in an amount of the driving current due to the deterioration in characteristics of the light emitting element LD may be reduced, an image retention defect of the display panel caused by the increase in usage time may be reduced, and a lifespan of the display panel may be improved.

As shown in FIG. 2B, the pixel PXij-1 may include a pixel driving unit PDC-1 including two transistors T1 and T2 and a first capacitor C1. The pixel driving unit PDC-1 may be connected to a light emitting element LD, a write scan line GWLi, a data line DLj, and a second power line VSL. The pixel driving unit PDC-1 shown in FIG. 2B may have a circuit configuration corresponding to a circuit configuration obtained by removing the third to eighth transistors T3 to T8 and the second capacitor C2 from the pixel driving unit PDC shown in FIG. 2A.

Each of the first and second transistors T1 and T2 may be an N-type transistor or a P-type transistor. In an embodiment, each of the first and second transistors T1 and T2 will be described as the N-type transistor.

The first transistor T1 may include a gate connected to a first node N1, a first electrode connected to a second node N2, and a second electrode connected to a third node N3. The second node N2 may be connected to a first power line VDL, and the third node N3 may be connected to the second power line VSL. The first transistor T1 may be connected to the light emitting element LD via the second node N2 and may be connected to the second power line VSL via the third node N3. The first transistor T1 may be a driving transistor.

The second transistor T2 may include a gate receiving a write scan signal GW via the write scan line GWLi, a first electrode connected to the data line DLj, and a second electrode connected to the first node N1. The second transistor T2 may provide a data signal DATA to the first node N1 in response to the write scan signal GW applied thereto via the write scan line GWLi.

The first capacitor C1 may include an electrode connected to the first node N1 and an electrode connected to the third node N3. The first capacitor C1 may be charged with the data signal DATA applied to the first node N1.

The light emitting element LD may include an anode and a cathode. In an embodiment, the anode of the light emitting element LD may be connected to the first power line VDL, and the cathode of the light emitting element LD may be connected to the pixel driving unit PDC-1 via the second node N2. In an embodiment, the cathode of the light emitting element LD may be connected to the first transistor T1. The light emitting element LD may emit a light in response to an amount of current flowing through the first transistor T1 of the pixel driving unit PDC-1.

In an embodiment in which each of the first and second transistors T1 and T2 is the N-type transistor, the second node N2 at which the cathode of the light emitting element LD is connected to the pixel driving unit PDC-1 may correspond to a drain of the first transistor T1. That is, a variation of a gate-source voltage (Vgs) of the first transistor T1 caused by the light emitting element LD may be prevented. Accordingly, the change in the amount of driving current due to deterioration of the light emitting element LD may be reduced, the image retention defect of a display panel caused by the increase in usage time may be reduced, and the lifespan of the display panel may be improved.

Referring to FIG. 2C, the pixel PXij -2 may include a pixel driving unit PDC-2 that includes six transistors T1, T2, T3, T4a, T5a, and T6a and two capacitors C1 and C2.

The pixel driving unit PDC-2 may be connected to a light emitting element LD, a write scan line GWLi, a reset scan line GRLi, a compensation scan line GCLi, an i-th first emission line ESL1i (hereinafter, referred to as a first emission line), an i-th second emission line ESL2i (hereinafter, referred to as a second emission line), a data line DLj, a first power line VDL, a second power line VSL, a third power line VRL, and an initialization voltage line VIL.

The pixel driving unit PDC-2 shown in FIG. 2C may have a circuit configuration similar to a circuit configuration obtained by removing the fourth transistor T4 and the fifth transistor T5 from the pixel driving unit PDC shown in FIG. 2A. As the pixel driving unit PDC-2 has an area smaller than an area of the pixel driving unit PDC shown in FIG. 2A, high resolution may be implemented more readily.

Each of first, second, third, fourth, fifth, and sixth transistors T1, T2, T3, T4a, T5a, and T6a may be an N-type or P-type transistor. In an embodiment, each of the first, second, third, fourth, fifth, and sixth transistors T1, T2, T3, T4a, T5a, and T6a will be described as the N-type transistor as a representative example.

The first transistor T1 may include a gate connected to a first node N1, a first electrode connected to a second node N2, and a second electrode connected to a third node N3. The second node N2 may be connected to the first power line VDL, and the third node N3 may be connected to the second power line VSL. The first transistor T1 may be connected to the light emitting element LD via the second node N2 and may be connected to the second power line VSL via the third node N3. The first transistor T1 may be a driving transistor.

The second transistor T2 may include a gate receiving a write scan signal GW via the write scan line GWLi, a first electrode connected to the data line DLj, and a second electrode connected to the first node N1. The second transistor T2 may provide a data signal DATA to the first node N1 in response to the write scan signal GW applied thereto via the write scan line GWLi.

The third transistor T3 may be connected between the first node N1 and the reference voltage line VRL. A first electrode of the third transistor T3 may receive a reference voltage VREF via the reference voltage line VRL, and a second electrode of the third transistor T3 may be connected to the first node N1. In an embodiment, a gate of the third transistor T3 may receive a reset scan signal GR via the reset scan line GRLi. The third transistor T3 may be turned on in case that the reset scan signal GR is applied thereto via the reset scan line GRLi and may provide the reference voltage VREF to the first node N1.

The fourth transistor T4a may be connected between the first transistor T1 and the light emitting element LD. In detail, a gate of the fourth transistor T4a may receive a first emission signal EM1 via the first emission line ESL1i. A first electrode of the fourth transistor T4a may be connected to a cathode of the light emitting element LD via a fourth node N4, and a second electrode of the fourth transistor T4a may be connected to the first electrode of the first transistor T1 via the second node N2. The fourth transistor T4a may be referred to as a first emission control transistor. The fourth transistor T4a may be turned on in case that the first emission signal EM1 is applied thereto via the first emission line ESL1i, and thus, the light emitting element LD may be electrically connected to the first transistor T1.

The fifth transistor T5a may be connected between the second power line VSL and the third node N3. A first electrode of the fifth transistor T5a may be connected to the second electrode of the first transistor T1 via the third node N3, and a second electrode of the fifth transistor T5a may receive a second power voltage VSS via the second power line VSL. A gate of the fifth transistor T5a may be electrically connected to the second emission line ESL2i. The fifth transistor T5a may be referred to as a second emission control transistor. The fifth transistor T5a may be turned on in case that a second emission signal EM2 is applied thereto via the second emission line ESL2i, and thus, the second electrode of the first transistor T1 may be electrically connected to the second power line VSL.

In an embodiment, the fourth transistor T4a and the fifth transistor T5a may be connected to the first and second emission lines ESL1i and ESL2i distinguished from each other, respectively, and may be turned on in response to the first and second emission signals EM1 and EM2 distinguished from each other, respectively. That is, the fourth transistor T4a and the fifth transistor T5a may be independently turned on, however, this is merely an example. As an example, the fourth transistor T4a and the fifth transistor T5a may be connected to the same emission line and may be controlled by the same emission signal. In addition, the fourth transistor T4a or the fifth transistor T5a may be omitted from the pixel driving unit PDC-2.

The sixth transistor T6a may be connected between the initialization voltage line VIL, and the fourth node N4. That is, the sixth transistor T6a may include a gate connected to the compensation scan line GCLi, a first electrode connected to the initialization voltage line VIL, and a second electrode connected to the fourth node N4. The sixth transistor T6a may be referred to as an initialization transistor. The sixth transistor T6a may provide an initialization voltage VINT to the fourth node N4 corresponding to the cathode of the light emitting element LD in response to a compensation scan signal GC applied thereto via the compensation scan line GCLi. The cathode of the light emitting element LD may be initialized by the initialization voltage VINT.

A first capacitor C1 may be disposed between the first node N1 and the third node N3. The first capacitor C1 may be charged with a voltage corresponding to a difference between a voltage of the first node N1 and a voltage of the third node N3. The first capacitor C1 may be referred to as a storage capacitor.

A second capacitor C2 may be disposed between the third node N3 and the second power line VSL. That is, an electrode of the second capacitor C2 may be connected to the second power line VSL to which the second power voltage VSS is applied, and another electrode of the second capacitor C2 may be connected to the third node N3. The second capacitor C2 may be charged with electric charges corresponding to a difference in voltage between the second power voltage VSS and the third node N3. The second capacitor C2 may be referred to as a hold capacitor.

The light emitting element LD may include an anode and the cathode. In an embodiment, the anode of the light emitting element LD may be connected to the first power line VDL, and the cathode of the light emitting element LD may be connected to the pixel driving unit PDC-2 via the fourth node N4. In an embodiment, the cathode of the light emitting element LD may be connected to the first transistor T1 via the fourth transistor T4a. The light emitting element LD may emit a light in response to an amount of current flowing through the first transistor T1 of the pixel driving unit PDC-2.

In an embodiment in which each of the first, second, third, fourth, fifth, and sixth transistors T1, T2, T3, T4a, T5a, and T6a is the N-type transistor, an electric potential of the third node N3 corresponding to a source of the first transistor T1, which is the driving transistor, may not be directly affected by characteristics of the light emitting element LD. Accordingly, even though the light emitting element LD is deteriorated, an influence of the deterioration of the light emitting element LD on a gate-source voltage (Vgs) of the transistors constituting the pixel driving unit PDC-2, especially the driving transistor, may be reduced. That is, since a change in an amount of a driving current due to the deterioration of the light emitting element LD may be reduced, an image retention defect of the display panel caused by the increase in usage time may be reduced, and a lifespan of the display panel may be improved.

FIGS. 2A, 2B, and 2C show circuits of the pixel driving units PDC, PDC-1, and PDC-2 according to embodiments of the disclosure, and the number and arrangement of the transistors and the number and arrangement of the capacitors may be designed in various ways as long as the circuits are connected to the cathode of the light emitting element LD in the display panel.

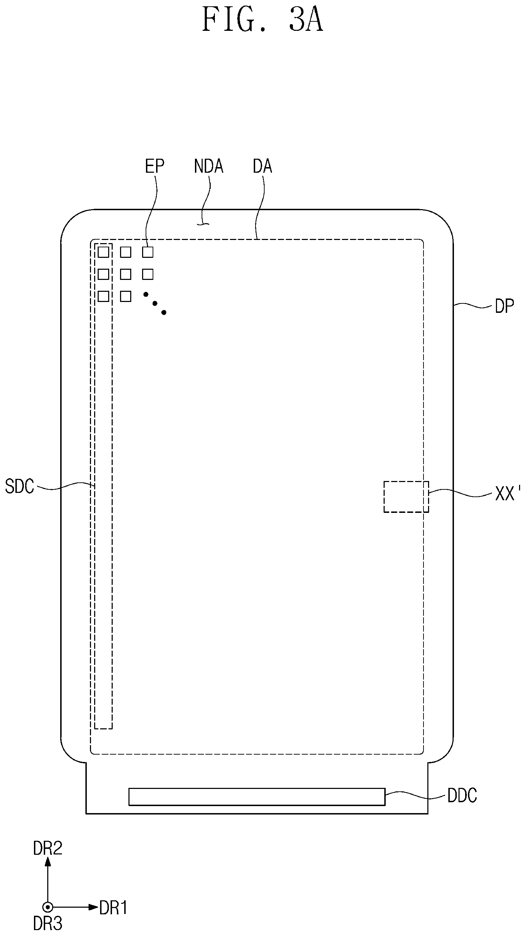

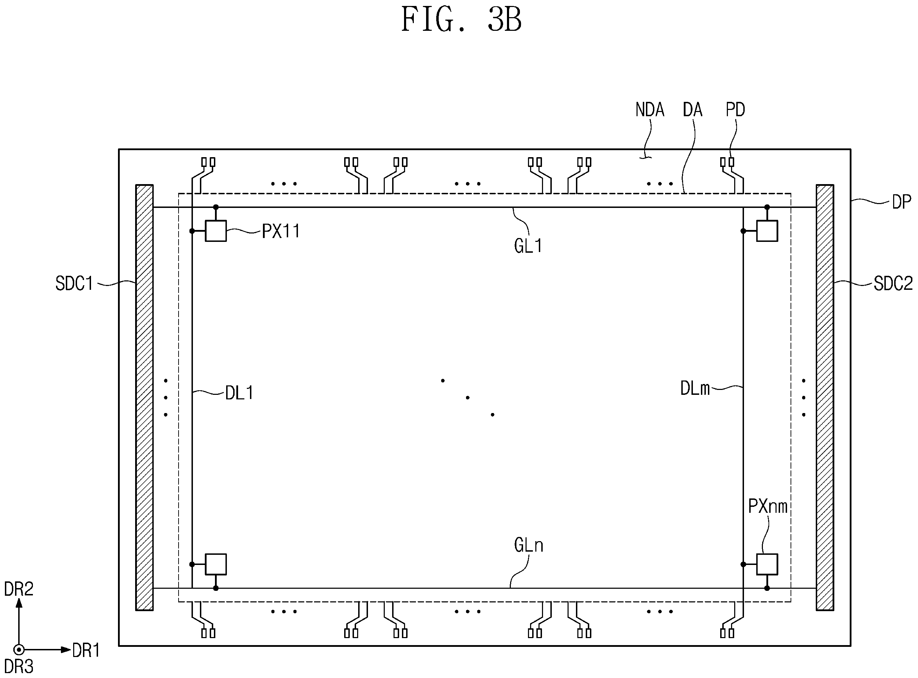

FIGS. 3A and 3B are schematic plan views of display panels according to embodiments of the disclosure. For the convenience of explanation, some components are omitted in each of FIGS. 3A and 3B. Hereinafter, the disclosure will be described with reference to FIGS. 3A and 3B.

Referring to FIG. 3A, the display panel DP may include a display area DA and a peripheral area (or a non-display area) NDA. The display area DA may include light emitting portions EP.

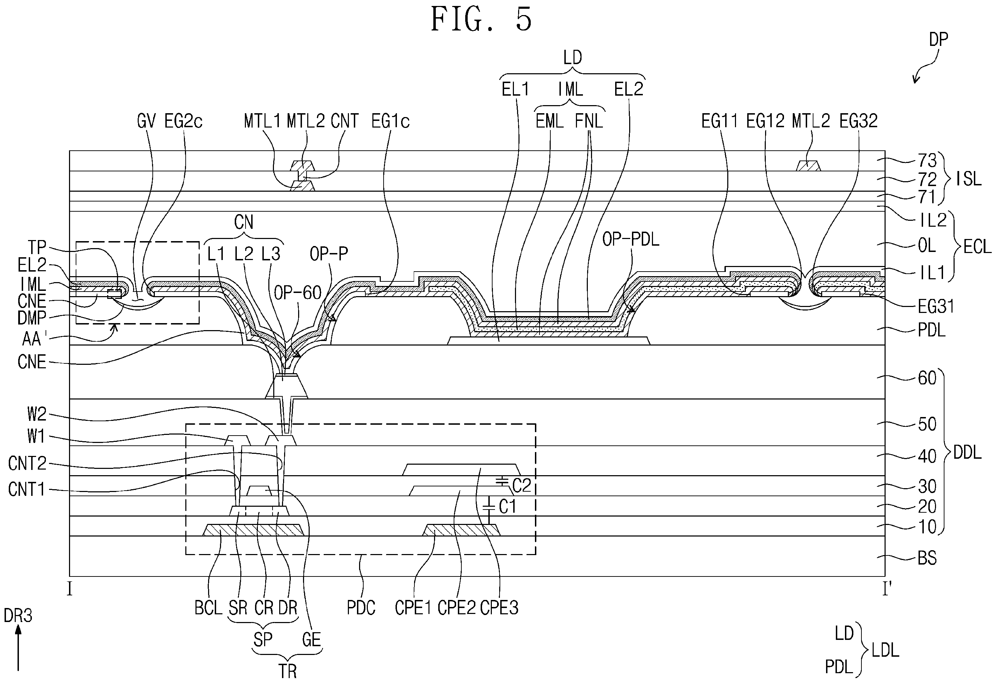

The light emitting portions EP may be areas where the pixels PXij (refer to FIG. 1) emit the light. In detail, each of the light emitting portions EP may correspond to a light emitting opening OP-PDL (refer to FIG. 5) described later.

The peripheral area NDA may be defined adjacent to the display area DA. In an embodiment, the peripheral area NDA may have a shape surrounding an edge of the display area DA, however, this is merely an example. According to an embodiment, the peripheral area NDA may be defined adjacent to one side of the display area DA or may be omitted.

In an embodiment, a scan driver SDC and a data driver DDC may be mounted on the display panel DP. The scan driver SDC may be disposed in the display area DA, and the data driver DDC may be disposed in the peripheral area NDA. The scan driver SDC may overlap at least some of the light emitting portions EP arranged in the display area DA in plan view. As the scan driver SDC is disposed in the display area DA, a size of the peripheral area NDA may be reduced compared with that of a conventional display panel in which a scan driver is disposed in a peripheral area, and thus, a narrow bezel of the display device may be readily implemented.

Different from the scan driver SDC shown in FIG. 3A, the scan driver SDC may be provided in two parts distinguished from each other. The two scan drivers SDC may be respectively disposed at left and right sides of the display area DA and may be spaced apart from each other. According to an embodiment, three or more scan drivers SDC may be employed, but the number of the scan drivers SDC should not be particularly limited.

FIG. 3A shows a representative example of the display panel, and the data driver DDC may be disposed in the display area DA. In the case where the data driver DDC is disposed in the display area DA, some of the light emitting portions EP arranged in the display area DA may overlap the data driver DDC in plan view.

According to an embodiment, the data driver DDC may be provided in a separate driving chip independently formed from the display panel DP and may be connected to the display panel DP, however, this is merely an example. According to an embodiment, the data driver DDC may be formed through the same process as the scan driver SDC to form the display panel DP, and embodiments should not be limited thereto or thereby.

Referring to FIG. 3B, the display panel DP may have a length in a first direction DR1, which is longer than a length in a second direction DR2. The display panel DP may include pixels PX11 to PXnm arranged in the display area DA in n rows by m columns. In an embodiment, the display panel DP may include scan drivers SDC1 and SDC2. The scan drivers SDC1 and SDC2 may include a first scan driver SDC1 and a second scan driver SDC2, which are spaced apart from each other in the first direction DR1.

The first scan driver SDC1 may be connected to some scan lines of scan lines GL1 to GLn, and the second scan driver SDC2 may be connected to the other scan lines among the scan lines GL1 to GLn. As an example, the first scan driver SDC1 may be connected to odd-numbered scan lines among the scan lines GL1 to GLn, and the second scan driver SDC2 may be connected to even-numbered scan lines among the scan lines GL1 to GLn.

For the convenience of explanation, FIG. 3B shows pads PD of data lines DL1 to DLm. The pads PD may be placed at ends of the data lines DL1 to DLm. The data lines DL1 to DLm may be connected to a data driver (refer to DDC of FIG. 3A) via the pads PD.

According to the disclosure, the pads PD may be arranged in areas of the peripheral area NDA, which are spaced apart from each other with the display area DA between the areas of the peripheral area NDA. As an example, some pads among the pads PD may be arranged in an upper portion of the display panel DP, which is adjacent to a first scan line GL1 among the scan lines GL1 to GLn, and the other pads among the pads PD may be arranged in a lower portion of the display panel DP, which is adjacent to the last scan line GLn among the scan lines GL1 to GLn. In an embodiment, pads, which are connected to odd-numbered data lines, among the pads PD may be arranged in the upper portion, and pads, which are connected to even-numbered data lines, among the pads PD may be arranged in the lower portion.

Although not shown in figures, the display panel DP may include upper data drivers connected to the pads PD arranged in the upper portion and lower data drivers connected to the pads PD arranged in the lower portion, however, these are merely examples. According to an embodiment, the display panel DP may include an upper data driver connected to the pads arranged in the upper portion and a lower data driver connected to the pads arranged in the lower portion. According to an embodiment, the pads PD may be arranged only in one side portion and may be connected to a single data driver, and the disclosure should not be particularly limited.

In addition, as described with reference to FIG. 3A, the scan driver and/or the data driver of the display panel DP of FIG. 3B may be disposed in the display area DA, and thus, some of the light emitting portions arranged in the display area DA may overlap the scan driver and/or the data driver in plan view.

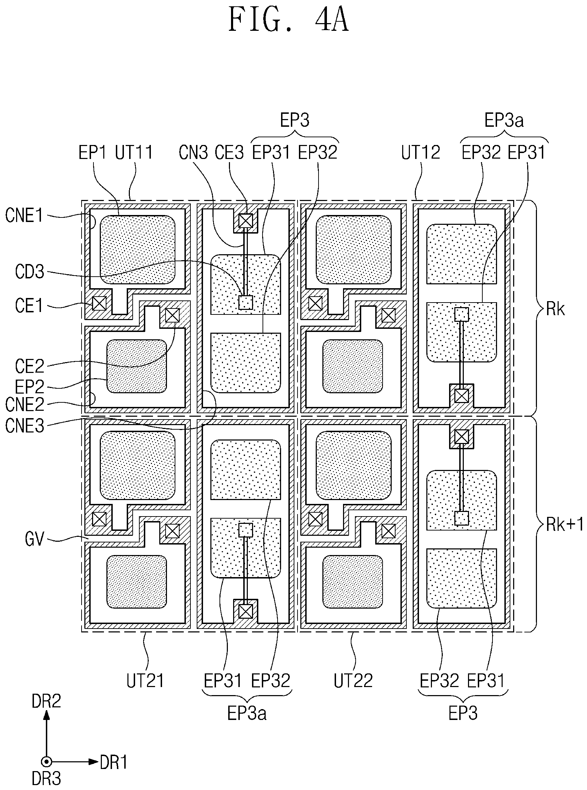

FIGS. 4A to 4D are enlarged schematic plan views of some areas of the display panel according to an embodiment of the disclosure.

FIG. 4A shows light emitting units UT11, UT12, UT21, and UT22 arranged in two rows by two columns. Referring to FIG. 4A, light emitting portions arranged in a first row Rk may include light emitting portions constituting the light emitting unit UT11 arranged in the first row and a first column and the light emitting unit UT12 arranged in the first row and a second column, and light emitting portions arranged in a second row Rk+1 may include light emitting portions constituting the light emitting unit UT21 arranged in the second row and the first column and the light emitting unit UT22 arranged in the second row and the second column.

Each of light emitting portions EP1, EP2, and EP3 may correspond to the light emitting opening OP-PDL (refer to FIG. 5) described later. That is, each of the light emitting portions EP1, EP2, and EP3 may be an area from which the light is emitted by the light emitting element. The light emitting portions EP1, EP2, and EP3 may correspond to a unit providing an image displayed through the display panel DP (refer to FIG. 1). In more detail, each of the light emitting portions EP1, EP2, and EP3 may correspond to an area defined by the light emitting opening OP-PDL described later, in particular, an area defined by a lower part of the light emitting opening OP-PDL.

The light emitting portions EP1, EP2, and EP3 may include a first light emitting portion EP1, a second light emitting portion EP2, and a third light emitting portion EP3. The first light emitting portion EP1, the second light emitting portion EP2, and the third light emitting portion EP3 may emit lights having different colors from each other. As an example, the first light emitting portion EP1 may emit a red light, the second light emitting portion EP2 may emit a green light, and the third light emitting portion EP3 may emit a blue light, however, a combination of colors of the first, second, and third light emitting portions EP1, EP2, and EP3 should not be limited thereto or thereby. In addition, at least two of the light emitting portions EP1, EP2, and EP3 may emit lights having the same color. For instance, all the first, second, and third light emitting portions EP1, EP2, and EP3 may emit a blue light or a white light.

Among the first, second, and third light emitting portions EP1, EP2, and EP3, the third light emitting portion EP3 in which the image corresponding to the light emitted by a third light emitting element is displayed may include two sub-light emitting portions EP31 and EP32 spaced apart from each other in the second direction DR2, however, this is merely an example. According to an embodiment, the third light emitting portion EP3 may be provided in a single pattern formed as a single body like the first and second light emitting portions EP1 and EP2, or at least one of the first and second light emitting portions EP1 and EP2 may include sub-light emitting portions spaced apart from each other, and the disclosure should not be particularly limited.

The light emitting portions arranged in the first row Rk may include first, second, and third light emitting portions EP1, EP2, and EP3 constituting the light emitting unit UT11 arranged in the first row and the first column and first, second, and third light emitting portions EP1, EP2, and EP3a constituting the light emitting unit UT12 arranged in the first row and the second column, and the light emitting portions arranged in the second row Rk+1 may include first, second, and third light emitting portions EP1, EP2, and EP3a constituting the light emitting unit UT21 arranged in the second row and the first column and first, second, and third light emitting portions EP1, EP2, and EP3 constituting the light emitting unit UT22 arranged in the second row and the second column.

The light emitting portions constituting the light emitting unit UT11 arranged in the first row and the first column may have substantially the same shape as the light emitting portions constituting the light emitting unit UT22 arranged in the second row and the second column. In addition, the light emitting portions constituting the light emitting unit UT12 arranged in the first row and the second column may have substantially the same shape as the light emitting portions constituting the light emitting unit UT21 arranged in the second row and the first column. The light emitting portions constituting the light emitting unit UT11 arranged in the first row and the first column may have the shape different from the shape of the light emitting portions constituting the light emitting unit UT12 arranged in the first row and the second column. As an example, some of the light emitting portions arranged in the first row Rk may have a symmetrical shape with respect to a shape of some of the light emitting portions arranged in the second row Rk+1.

The third light emitting portion EP3a of the light emitting unit UT21 arranged in the second row and the first column and the third light emitting portion EP3 of the light emitting unit UT11 arranged in the first row and the first column may have a line-symmetrical shape and arrangement with respect to an axis substantially parallel to the first direction DR1, and the third light emitting portion EP3 of the light emitting unit UT22 arranged in the second row and the second column and the third light emitting portion EP3a of the light emitting unit UT12 arranged in the first row and the second column may have a line-symmetrical shape and arrangement with respect to the axis substantially parallel to the first direction DR1, however, the disclosure should not be limited thereto or thereby.

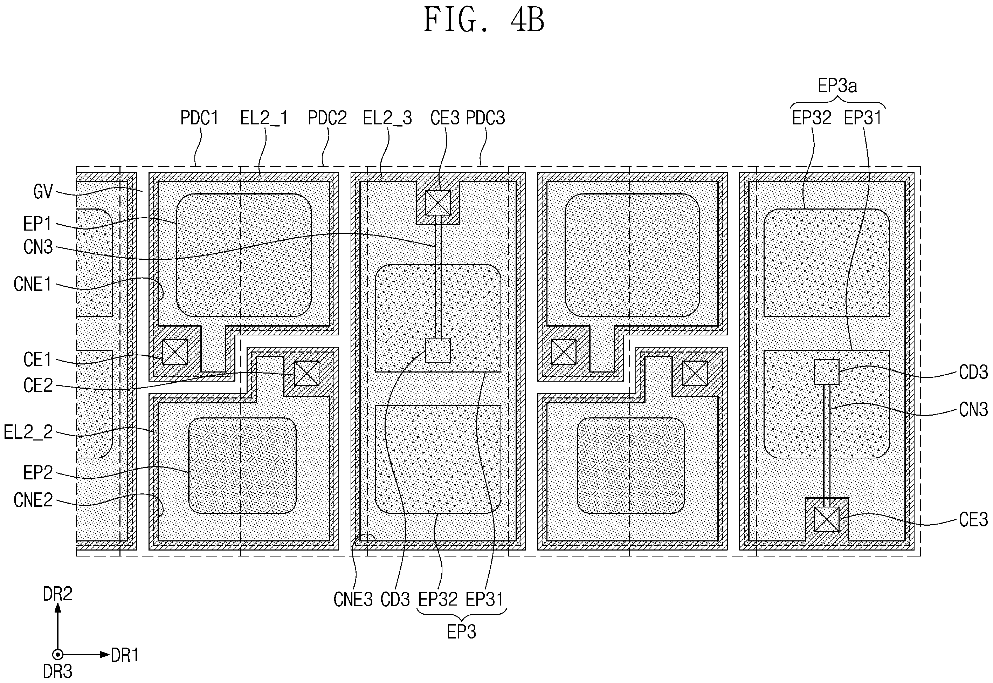

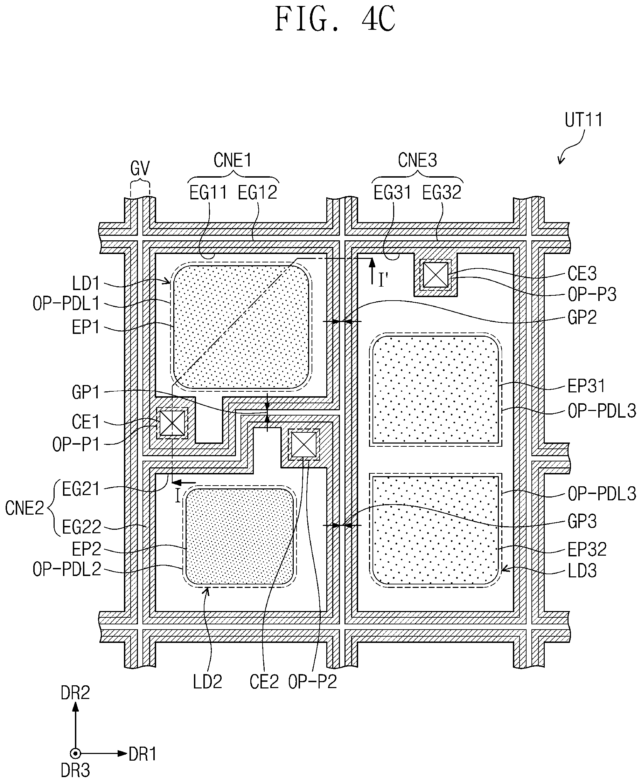

FIG. 4B shows the light emitting portions arranged in one row. For the convenience of explanation, FIG. 4B shows second electrodes EL2_1, EL2_2, and EL2_3, pixel driving units PDC1, PDC2, and PDC3, first, second, and third connection electrodes CNE1, CNE2, and CNE3, and a groove GV. FIG. 4C shows the groove GV, the light emitting portions EP1, EP2, and EP3 disposed in areas defined by the groove GV, and the connection electrodes CNE1, CNE2, and CNE3 among components of the display panel.

Referring to FIGS. 4B and 4C, the second electrodes EL2_1, EL2_2, and EL2_3 may be separated from each other by the groove GV and may be electrically disconnected from each other. In an embodiment, a light emitting unit UT11 may include three light emitting portions EP1, EP2, and EP3. Accordingly, the light emitting unit UT11 may include three second electrodes EL2_1, EL2_2, and EL2_3 (hereinafter, referred to as first, second, and third cathodes), three pixel driving units PDC1, PDC2, and PDC3, and three connection electrodes CNE1, CNE2, and CNE3, however, this is merely an example. The number and arrangement of the light emitting portions included in the light emitting unit UT11 may be designed in various ways, and the disclosure should not be particularly limited.

First, second, and third pixel driving units PDC1, PDC2, and PDC3 may be respectively electrically connected to first, second, and third light emitting elements LD1, LD2, and LD3 (see Fig. 4C) including the first, second, and third light emitting portions EP1, EP2, and EP3. In the disclosure, the expression that a component A is connected to a component B may mean not only a case where the component A is directly and physically connected to the component B, but also a case where the component A is electrically connected to the component B.

In addition, as shown in FIG. 4B, each of areas where the first, second, and third pixel driving units PDC1, PDC2, and PDC3 are defined in plan view may correspond to a unit including transistors and capacitors constituting the pixel driving circuit PDC (refer to FIG. 2A) to drive the light emitting element of the pixel.

The first, second, and third pixel driving units PDC1, PDC2, and PDC3 may be sequentially arranged in the first direction DR1. The arrangement positions of the first, second, and third pixel driving units PDC1, PDC2, and PDC3 may be designed independently from positions and shapes of the first, second, and third light emitting portions EP1, EP2, and EP3.

As an example, the first, second, and third pixel driving units PDC1, PDC2, and PDC3 may be placed at positions different from the areas divided by the groove GV, i.e., positions at which the first, second, and third cathodes EL2_1, EL2_2, and EL2_3 are placed, or may be designed to have shapes and sizes different from the shapes and sizes of the first, second, and third cathodes EL2_1, EL2_2, and EL2_3. According to an embodiment, the first, second, and third pixel driving units PDC1, PDC2, and PDC3 may be placed to respectively overlap the positions at which the first, second, and third light emitting portions EP1, EP2, and EP3 are placed and may be designed to have shapes and sizes similar to those of the areas divided by the groove GV, i.e., shapes and sizes of the first, second, and third cathodes EL2_1, EL2_2, and EL2_3.

In an embodiment, each of the first, second, and third pixel driving units PDC1, PDC2, and PDC3 may have a rectangular shape, each of the first, second, and third light emitting portions EP1, EP2, and EP3 may have a size smaller than and a shape different from those of the first, second, and third pixel driving units PDC1, PDC2, and PDC3, and the first, second, and third cathodes EL2_1, EL2_2, and EL2_3 may be placed at positions overlapping the first, second, and third light emitting portions EP1, EP2, and EP3 and may have an atypical shape.

Accordingly, as shown in FIG. 4B, the first pixel driving unit PDC1 may be placed at a position overlapping the first light emitting portion EP1, the second light emitting portion EP2, and a portion of another light emitting unit adjacent to the first light emitting portion EP1 and the second light emitting portion EP2.. The second pixel driving unit PDC2 may be placed at a position overlapping the first light emitting portion EP1, the second light emitting portion EP2, and the third cathode EL2_3. The third pixel driving unit PDC3 may be placed at a position overlapping the third light emitting portion EP3, however, these are merely examples. According to an embodiment, the arrangement positions of the first, second, and third pixel driving units PDC1, PDC2, and PDC3 may be designed independently from the positions and shapes of the light emitting portions EP1, EP2, and EP3 and should not be particularly limited.

The light emitting unit UT11 may include the first, second, and third connection electrodes CNE1, CNE2, and CNE3. The first connection electrode CNE1 may electrically connect the first light emitting element LD1 in which the first light emitting portion EP1 is formed (or the first light emitting portion EP1 is defined) and the first pixel driving unit PDC1, the second connection electrode CNE2 may electrically connect the second light emitting element LD2 in which the second light emitting portion EP2 is formed and the second pixel driving unit PDC2, and the third connection electrode CNE3 may electrically connect the third light emitting element LD3 in which the third light emitting portion EP3 is formed and the third pixel driving unit PDC3.

In detail, the first, second, and third connection electrodes CNE1, CNE2, and CNE3 may electrically connect the first, second, and third cathodes EL2_1, EL2_2, and EL2_3 and the first, second, and third pixel driving units PDC1, PDC2, and PDC3 in a one-to-one correspondence.

Each of the first, second, and third connection electrodes CNE1, CNE2, and CNE3 may be disposed on a pixel definition layer PDL (refer to FIG. 5) described later. Each of the first, second, and third connection electrodes CNE1, CNE2, and CNE3 may have a ring shape to surround a corresponding light emitting portion among the first, second, and third light emitting portions EP1, EP2, and EP3. In an embodiment, each of the first, second, and third connection electrodes CNE1, CNE2, and CNE3 may have a closed ring shape as a representative example, however, embodiments should not be limited thereto or thereby. As an example, at least one of the first, second, and third connection electrodes CNE1, CNE2, and CNE3 may have an open ring shape of which a portion is cut.

As the first, second, and third connection electrodes CNE1, CNE2, and CNE3 have the ring shape, the degree of freedom in connection positions, where the first, second, and third connection electrodes CNE1, CNE2, and CNE3 are connected to the first, second, and third pixel driving units PDC1, PDC2, and PDC3, may be improved. As an example, the first connection electrode CNE1 may be connected to the first pixel driving unit PDC1 via a first connection portion CE1, the second connection electrode CNE2 may be connected to the second pixel driving unit PDC2 via a second connection portion CE2, and the third connection electrode CNE3 may be connected to the third pixel driving unit PDC3 via a connection line CN3. That is, connection lines additionally connected to the first and second connection electrodes CNE1 and CNE2 may be omitted.

A connection line CN3 may electrically connect the third pixel driving unit PDC3 and the third light emitting element LD3 of the third light emitting portion EP3. In detail, the connection line CN3 may correspond to the node (refer to the fourth node N4 of FIG. 2A, the second node N2 of FIG. 2B, or the fourth node N4 of FIG. 2C) at which the light emitting element LD (refer to FIG. 2A) is connected to the pixel driving unit PDC of FIG. 2A, PDC-1 of FIG. 2B, or PDC-2 of FIG. 2C.

The connection line CN3 may include a third connection portion CE3 and a driving connection portion CD3. The third connection portion CE3 may be provided at an end of the connection line CN3, and the driving connection portion CD3 may be provided at another end of the connection line CN3.

The driving connection portion CD3 may be a portion of the connection line CN3, which is connected to the pixel driving unit PDC3. In an embodiment, the driving connection portion CD3 may be connected to an electrode of the transistor of the pixel driving unit PDC3. In detail, the driving connection portion CD3 may be connected to the drain of the sixth transistor T6 shown in FIG. 2A, the drain of the first transistor T1 shown in FIG. 2B, or the drain of the fourth transistor T4 shown in FIG. 2C. Accordingly, a position of the driving connection portion CD3 may correspond to a position of the transistor of the pixel driving unit, which is physically connected to the connection line CN3. The third connection portion CE3 may be a portion of the connection line CN3, which is connected to the third light emitting element LD3. In an embodiment, the third connection portion CE3 may be connected to the third connection electrode CNE3.

The first connection electrode CNE1 may include a first edge EG11 surrounding at least a portion of the first light emitting portion EP1 and a second edge EG12 surrounding the first edge EG11. The second connection electrode CNE2 may include a first edge EG21 surrounding at least a portion of the second light emitting portion EP2 and a second edge EG22 surrounding the first edge EG21. The third connection electrode CNE3 may include a first edge EG31 surrounding at least a portion of the third light emitting portion EP3 and a second edge EG32 surrounding the first edge EG31.

The first, second, and third connection electrodes CNE1, CNE2, and CNE3 may be arranged spaced apart from each other. As an example, gaps GP1, GP2, and GP3 between the connection electrodes adjacent to each other among the first, second, and third connection electrodes CNE1, CNE2, and CNE3 may overlap the groove GV. As an example, the first edges EG11, EG21, and EG31 of the first, second, and third connection electrodes CNE1, CNE2, and CNE3 need not overlap the groove GV, and the second edges EG12, EG22, and EG32 of the first, second, and third connection electrodes CNE1, CNE2, and CNE3 may overlap the groove GV.

The first, second, and third connection portions CE1, CE2, and CE3 may be disposed at positions that do not overlap the first, second, and third light emitting portions EP1, EP2, and EP3 in plan view. As an example, the light emitting opening OP-PDL (refer to FIG. 5) and through holes OP-P (refer to FIG. 5) spaced apart from the light emitting opening OP-PDL may be defined through the pixel definition layer PDL.

The through holes OP-P may include a first through hole OP-P1, a second through hole OP-P2, and a third through hole OP-P3. The first, second, and third connection portions CE1, CE2, and CE3 may be arranged corresponding to the first, second, and third through holes OP-P1, OP-P2, and OP-P3, respectively. The light emitting opening OP-PDL may include a first light emitting opening OP-PDL1, a second light emitting opening OP-PDL2, and a third light emitting opening OP-PDL3. The first, second, and third light emitting portions EP1, EP2, and EP3 may be defined to correspond to the first, second, and third light emitting openings OP-PDL1, OP-PDL2, and OP-PDL3, respectively. Accordingly, the first, second, and third connection portions CE1, CE2, and CE3 may be arranged at positions spaced apart from the first, second, and third light emitting portions EP1, EP2, and EP3.

The first, second, and third connection electrodes CNE1, CNE2, and CNE3 may be disposed on the pixel definition layer PDL (refer to FIG. 5). In plan view, the first connection electrode CNE1 may surround the first light emitting opening OP-PDL1, the second connection electrode CNE2 may surround the second light emitting opening OP-PDL2, and the third connection electrode CNE3 may surround the third light emitting openings OP-PDL3.

The driving connection portion CD3, which is the portion of the connection line CN3 where a transistor TR (refer to FIG. 5) of the third pixel driving unit PDC3 is connected to the connection line CN3, may be defined at a position that does not overlap the third connection portion CE3 in plan view and may be disposed at a position overlapping the third light emitting portion EP3. As the third cathode EL2_3 is connected to the third pixel driving unit PDC3 via the connection line CN3, restrictions on the design of the third pixel driving unit PDC3 due to the position or shape of the third light emitting portion EP3 may be reduced, and the degree of freedom in circuit design may be improved.

The first, second, and third cathodes EL2_1, EL2_2, and EL2_3 may be connected to the first, second, and third connection electrodes CNE1, CNE2, and CNE3. As an example, the first, second, and third cathodes EL2_1, EL2_2, and EL2_3 may be connected to the first, second, and third connection electrodes CNE1, CNE2, and CNE3, respectively, in areas adjacent to the groove GV.

In addition, the connection areas in which the first, second, and third cathodes EL2_1, EL2_2, and EL2_3 are connected to the first, second, and third connection electrodes CNE1, CNE2, and CNE3 may surround at least a portion of the first, second, and third light emitting openings OP-PDL1, OP-PDL2, and OP-PDL3, respectively. The first, second, and third cathodes EL2_1, EL2_2, and EL2_3 may be connected to the first, second, and third connection electrodes CNE1, CNE2, and CNE3 in the areas adjacent to the groove GV, and each of the connection areas may be defined adjacent to the groove GV. That is, the first, second, and third cathodes EL2_1, EL2_2, and EL2_3 need not be connected to the first, second, and third connection electrodes CNE1, CNE2, and CNE3 at specific points, but may be connected to the first, second, and third connection electrodes CNE1, CNE2, and CNE3 over a relatively large area, for example, over an area having a shape similar to each of the first, second, and third connection electrodes CNE1, CNE2, and CNE3. That is, a size of the connection area may increase, and thus, the connection between the first, second, and third cathodes EL2_1, EL2_2, and EL2_3 and the first, second, and third connection electrodes CNE1, CNE2, and CNE3 may be stable.

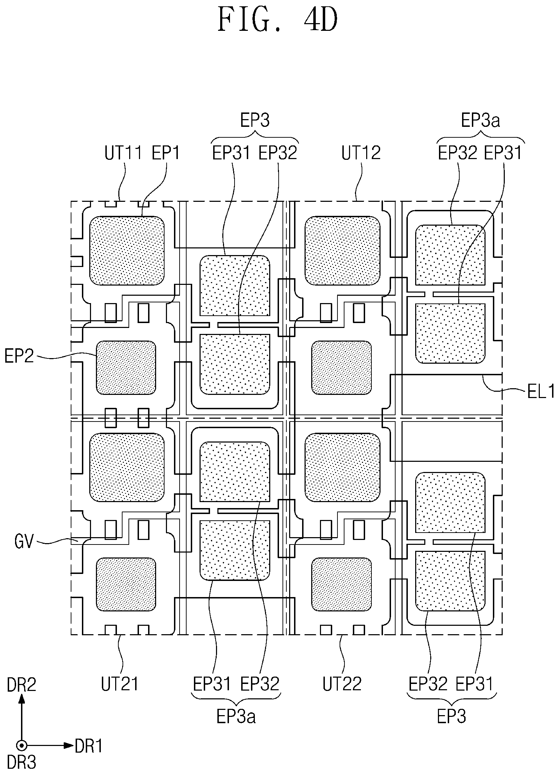

FIG. 4D shows the groove GV, the light emitting portions EP1, EP2, and EP3, and a first electrode EL1.

Referring to FIG. 4D, the first electrode EL1 (hereinafter, referred to as an anode) of the light emitting element LD (refer to FIG. 5) may be commonly disposed in the light emitting portions EP1, EP2, and EP3. That is, the anode EL1 may have a single body layer over the display area DA, and thus, the anode EL1 may overlap the groove GV. According to an embodiment, anodes EL1 of the light emitting elements LD may be formed as conductive patterns independent from each other and may be electrically connected to each other via other conductive layers, and thus, the anodes EL1 may be disposed not to overlap the groove GV.

As described above, the first power voltage VDD (refer to FIG. 2A) may be applied to the anode EL1, and a common voltage may be applied to all the light emitting portions. The anode EL1 may be connected to the first power line VDL (refer to FIG. 2A) providing the first power voltage VDD in the peripheral area NDA or may be connected to the first power line VDL (refer to FIG. 2A) in the display area DA, and embodiments should not be limited thereto or thereby.

Openings may be defined through the anode EL1, and the openings may penetrate through the anode EL1. The openings defined through the anode EL1 may be defined not to overlap the light emitting portions EP (refer to FIG. 3A) and may be defined to substantially overlap the groove GV. The openings may facilitate a discharge of a gas generated from an organic layer disposed under the anode EL1, e.g., a sixth insulating layer 60 (refer to FIG. 5). Accordingly, as the gas from the organic layer disposed under the light emitting element is sufficiently discharged in a manufacturing process of the display panel DP, the gas generated from the organic layer after the manufacturing process is over may be reduced, and thus, the rate of deterioration of the light emitting element may decrease.

FIG. 5 is a schematic cross-sectional view of the display panel DP according to an embodiment of the disclosure. FIG. 5 shows a cross-sectional view taken along a ling I-I' of FIG. 4C.

Referring to FIG. 5, the display panel DP may include a base layer BS, a driving element layer DDL, a light emitting element layer LDL, an encapsulation layer ECL, and a sensing layer ISL, however, this is merely an example. According to an embodiment, the display panel DP need not include the sensing layer ISL.

The driving element layer DDL may include insulating layers 10, 20, 30, 40, 50, and 60 disposed on the base layer BS, and conductive patterns and semiconductor patterns, which are disposed between the insulating layers. The conductive patterns and the semiconductor patterns disposed between the insulating layers 10, 20, 30, 40, 50, and 60 may form the pixel driving unit PDC. For the convenience of explanation, FIG. 5 shows a cross-section of a portion of an area in which one light emitting portion is disposed.

The base layer BS may provide a base surface on which the pixel driving unit PDC is disposed. The base layer BS may be a rigid substrate or a flexible substrate that is bendable, foldable, or rollable. The base layer BS may be a glass substrate, a metal substrate, or a polymer substrate, however, embodiments should not be limited thereto or thereby. According to an embodiment, the base layer BS may be an inorganic layer, an organic layer, or a composite material layer.

The base layer BS may have a multi-layer structure. The base layer BS may include a first polymer resin layer, a silicon oxide (SiOx) layer disposed on the first polymer resin layer, an amorphous silicon (a-Si) layer disposed on the silicon oxide layer, and a second polymer resin layer disposed on the amorphous silicon (a-Si) layer. The silicon oxide (SiOx) layer and the amorphous silicon (a-Si) layer may be referred to as a base barrier layer.

Each of the first and second polymer resin layers may include a polyimide-based resin. In addition, each of the first and second polymer resin layers may include at least one of an acrylic-based resin, a methacrylic-based resin, a polyisoprene-based resin, a vinyl-based resin, an epoxy-based resin, a urethane-based resin, a cellulose-based resin, a siloxane-based resin, a polyamide-based resin, and a perylene-based resin. In the disclosure, the term "X-based resin", as used herein, refers to the resin that includes a functional group of X.

Insulating layers, conductive layers, and semiconductor layers, which are disposed on the base layer BS, may be formed through coating and deposition processes. The insulating layers, the semiconductor layers, and the conductive layers may be selectively patterned through several photolithography processes, and thus, holes may be defined through the insulating layers or the semiconductor pattern, the conductive pattern, and the signal line may be formed.

The driving element layer DDL may include first, second, third, fourth, fifth, and sixth insulating layers 10, 20, 30, 40, 50, and 60 sequentially stacked on the base layer BS and the pixel driving unit PDC. FIG. 5 shows one transistor TR and two capacitors C1 and C2 of the pixel driving unit PDC.

The transistor TR may correspond to a transistor connected to the light emitting element LD via an intermediate connection electrode CN and a connection electrode CNE, i.e., a connection transistor connected to the node (the fourth node N4 of FIG. 2A, the second node N2 of FIG. 2B, or the fourth node N4 of FIG. 2C) corresponding to the cathode of the light emitting element LD. In detail, the transistor TR may correspond to the sixth transistor T6 of FIG. 2A, the first transistor T1 of FIG. 2B, or the fourth transistor T4a of FIG. 2C. Although not shown in figures, other transistors constituting the pixel driving unit PDC may have substantially the same structure as that of the transistor TR (hereinafter, referred to as the connection transistor) shown in FIG. 5, however, this is merely an example. According to an embodiment, other transistors constituting the pixel driving unit PDC may have a structure different from the connection transistor TR and should not be particularly limited.

The first insulating layer 10 may be disposed on the base layer BS. The first insulating layer 10 may be an inorganic layer and/or an organic layer and may have a single-layer or multi-layer structure. The first insulating layer 10 may include at least one of aluminum oxide, titanium oxide, silicon oxide, silicon nitride, silicon oxynitride, zirconium oxide, and hafnium oxide. In an embodiment, the first insulating layer 10 may have a single-layer structure of a silicon oxide layer. Insulating layers described later may be an inorganic layer and/or an organic layer and may have a single-layer or multi-layer structure. The inorganic layer may include at least one of the above-mentioned materials, however, embodiments should not be limited thereto or thereby.

The first insulating layer 10 may cover a lower conductive layer BCL. That is, the display panel DP may further include the lower conductive layer BCL overlapping the connection transistor TR. The lower conductive layer BCL may prevent an electric potential caused by a polarization phenomenon of the base layer BS from exerting influence on the connection transistor TR. In addition, the lower conductive layer BCL may block a light incident into the connection transistor TR from a lower side of the lower conductive layer BCL. At least one of an inorganic barrier layer and a buffer layer may be further disposed between the lower conductive layer BCL and the base layer BS.

The lower conductive layer BCL may include a reflective metal material. As an example, the lower conductive layer BCL may include titanium (Ti), molybdenum (Mo), an alloy including molybdenum (Mo), aluminum (Al), an alloy including aluminum (Al), aluminum nitride (AlN), tungsten (W), tungsten nitride (WN), and copper (Cu).

In an embodiment, the lower conductive layer BCL may be connected to a source of the connection transistor (or the transistor) TR via a source electrode pattern W1. The lower conductive layer BCL may be synchronized with the source of the transistor TR, however, this is merely an example. According to an embodiment, the lower conductive layer BCL may be connected to and synchronized with a gate of the transistor TR. According to an embodiment, the lower conductive layer BCL may be connected to another electrode to independently receive a constant voltage or a pulse signal. According to an embodiment, the lower conductive layer BCL may be provided in an isolated form isolated from other conductive patterns. The lower conductive layer BCL may be provided in a variety of shapes and should not be particularly limited.

The connection transistor TR may be disposed on the first insulating layer 10. The connection transistor TR may include a semiconductor pattern SP and a gate electrode GE. The semiconductor pattern SP may be disposed on the first insulating layer 10. The semiconductor pattern SP may include an oxide semiconductor. As an example, the oxide semiconductor may include a transparent conductive oxide (TCO), such as indium tin oxide (ITO), indium zinc oxide (IZO), indium gallium zinc oxide (IGZO), zinc oxide (ZnO), indium oxide (In₂O₃), or the like, however, the material for the semiconductor pattern SP should not be limited thereto or thereby. As an example, the semiconductor pattern SP may include amorphous silicon, low temperature polycrystalline silicon, or polycrystalline silicon.

The semiconductor pattern SP may include a source area SR, a drain area DR, and a channel area CR distinguished from each other depending on a degree of conductivity. The channel area CR may overlap the gate electrode GE in plan view. The source area SR and the drain area DR may be spaced apart from each other with the channel area CR between the source area SR and the drain area DR. In case that the semiconductor pattern SP is the oxide semiconductor, each of the source area SR and the drain area DR may be a reduced area. Accordingly, the source area SR and the drain area DR may have a relatively high content of reduced metal compared with the channel area CR. According to an embodiment, in case that the semiconductor pattern SP is the polycrystalline silicon, each of the source area SR and the drain area DR may be a highly doped area.

The source area SR and the drain area DR may have a relatively high conductivity compared with the channel area CR. The source area SR may correspond to a source electrode of the connection transistor TR, and the drain area DR may correspond to a drain electrode of the connection transistor TR. As shown in FIG. 5, the connection transistor TR may further include the source electrode pattern W1 and a drain electrode pattern W2, which are separated from each other and respectively connected to the source area SR and the drain area DR. In detail, each of the source electrode pattern W1 and the drain electrode pattern W2 may be formed integrally with a line constituting the pixel driving unit PDC (refer to FIG. 2A), PDC-1 (refer to FIG. 2B), and PDC-2 (refer to FIG. 2C), however, embodiments should not be limited thereto or thereby.

The second insulating layer 20 may commonly overlap the pixels and may cover the semiconductor pattern SP. The second insulating layer 20 may be an inorganic layer and/or an organic layer and may have a single-layer or multi-layer structure. The second insulating layer 20 may include at least one of aluminum oxide, titanium oxide, silicon oxide, silicon nitride, silicon oxynitride, zirconium oxide, and hafnium oxide. In an embodiment, the second insulating layer 20 may have a single-layer structure of a silicon oxide layer.

The gate electrode GE may be disposed on the second insulating layer 20. The gate electrode GE may correspond to the gate of the connection transistor TR. In addition, the gate electrode GE may be disposed on the semiconductor pattern SP, however, this is merely an example. According to an embodiment, the gate electrode GE may be disposed under the semiconductor pattern SP, and embodiments should not be particularly limited.

The gate electrode GE may include titanium (Ti), silver (Ag), molybdenum (Mo), aluminum (Al), aluminum nitride (AlN), tungsten (W), tungsten nitride (WN), copper (Cu), or an alloy thereof, however, embodiments should not be particularly limited.

The third insulating layer 30 may be disposed on the gate electrode GE. The third insulating layer 30 may be an inorganic layer and/or an organic layer and may have a single-layer or multi-layer structure.

Among conductive patterns W1, W2, CPE1, CPE2, and CPE3, a first capacitor electrode CPE1 and a second capacitor electrode CPE2 may form the first capacitor C1. The first capacitor electrode CPE1 and the second capacitor electrode CPE2 may be spaced apart from each other with the first insulating layer 10 and the second insulating layer 20 between the first capacitor electrode CPE1 and the second capacitor electrode CPE2.

According to an embodiment, the first capacitor electrode CPE1 and the lower conductive layer BCL may be integrally provided with each other. In addition, the second capacitor electrode CPE2 may be provided integrally with the gate electrode GE.

A third capacitor electrode CPE3 may be disposed on the third insulating layer 30. The third capacitor electrode CPE3 may be spaced apart from the second capacitor electrode CPE2 with the third insulating layer 30 between the third capacitor electrode CPE3 and the second capacitor electrode CPE2 and the third capacitor electrode CPE3 may overlap the second capacitor electrode CPE2 in plan view. The third capacitor electrode CPE3 and the second capacitor electrode CPE2 may form the second capacitor C2.

The fourth insulating layer 40 may be disposed on the third insulating layer 30 and/or the third capacitor electrode CPE3. The fourth insulating layer 40 may be an inorganic layer and/or an organic layer and may have a single-layer or multi-layer structure. The fourth insulating layer 40 may include at least one of aluminum oxide, titanium oxide, silicon oxide, silicon nitride, silicon oxynitride, zirconium oxide, and hafnium oxide

The source electrode pattern W1 and the drain electrode pattern W2 may be disposed on the fourth insulating layer 40. The source electrode pattern W1 may be connected to the source area SR of the connection transistor TR via a first contact hole CNT1, and the source electrode pattern W1 and the source area SR of the semiconductor pattern SP may serve as the source of the connection transistor TR. The drain electrode pattern W2 may be connected to the drain area DR of the connection transistor TR via a second contact hole CNT2, and the drain electrode pattern W2 and the drain area DR of the semiconductor pattern SP may serve as a drain of the connection transistor TR. The fifth insulating layer 50 may be disposed on the source electrode pattern W1 and the drain electrode pattern W2.

The intermediate connection electrode CN may be disposed on the fifth insulating layer 50. The intermediate connection electrode CN may electrically connect the pixel driving unit PDC to the light emitting element LD. That is, the intermediate connection electrode CN may electrically connect the connection transistor TR to the light emitting element LD. The intermediate connection electrode CN may be a connection node that connects the pixel driving unit PDC to the light emitting element LD. That is, the intermediate connection electrode CN may correspond to the fourth node N4 shown in FIG. 2A, may correspond to the second node N2 shown in FIG. 2B, or the fourth node N4 shown in FIG. 2C.

The intermediate connection electrode CN may include a first layer L1, a second layer L2, and a third layer L3, which are sequentially stacked in a third direction DR3. The second layer L2 may include a material different from that of the first layer L1. The second layer L2 may include a material different from that of the third layer L3. The second layer L2 may have a relatively thicker thickness than that of the first layer L1. The second layer L2 may have a relatively thicker thickness than that of the third layer L3. The second layer L2 may include a material with high conductivity. As an example, the second layer L2 may include aluminum (Al).

The sixth insulating layer 60 may be disposed on the intermediate connection electrode CN. The sixth insulating layer 60 may be disposed on the fifth insulating layer 50 and may cover at least a portion of the intermediate connection electrode CN. Each of the fifth insulating layer 50 and the sixth insulating layer 60 may be an organic layer. As an example, each of the fifth insulating layer 50 and the sixth insulating layer 60 may include a general-purpose polymer, such as benzocyclobutene (BCB), polyimide, hexamethyldisiloxane (HMDSO), polymethylmethacrylate (PMMA), or polystyrene (PS), a polymer derivative having a phenolic group, an acrylic-based polymer, an imide-based polymer, an aryl ether-based polymer, an amide-based polymer, and a fluorine-based polymer, a p-xylene-based polymer, a vinyl alcohol-based polymer, or blends thereof.

The sixth insulating layer 60 may be provided with a through hole OP-60 defined in the sixth insulating layer 60 to expose at least a portion of the intermediate connection electrode CN. The intermediate connection electrode CN may be connected to the connection electrode CNE via the portion exposed without being covered by the sixth insulating layer 60 and thus may be electrically connected to the light emitting element LD. That is, the intermediate connection electrode CN and the connection electrode CNE may electrically connect the connection transistor TR and the light emitting element LD. According to an embodiment, the sixth insulating layer 60 may be omitted, or multiple sixth insulating layers may be provided in the display panel DP, however, embodiments should not be particularly limited. In case that the sixth insulating layer 60 is omitted, the intermediate connection electrode CN may also be omitted.

According to an embodiment, since a lower surface of the connection electrode CNE is in contact with an upper surface of the intermediate connection electrode CN, a contact reliability may be improved. Accordingly, a size of the through hole OP-P required to connect the connection electrode CNE and the intermediate connection electrode CN may be reduced. Accordingly, a size and resolution of the light emitting portion of the display panel DP may readily increase.

The light emitting element layer LDL may be disposed on the driving element layer DDL. The light emitting element layer LDL may include the pixel definition layer PDL and the light emitting element LD.

The pixel definition layer PDL may be an organic layer. As an example, the pixel definition layer PDL may include a general-purpose polymer, such as benzocyclobutene (BCB), polyimide, hexamethyldisiloxane (HMDSO), polymethylmethacrylate (PMMA), or polystyrene (PS), a polymer derivative having a phenolic group, an acrylic-based polymer, an imide-based polymer, an aryl ether-based polymer, an amide-based polymer, and a fluorine-based polymer, a p-xylene-based polymer, a vinyl alcohol-based polymer, or blends thereof.

The pixel definition layer PDL may have a light absorbing property. For example, the pixel definition layer PDL may have a black color. That is, the pixel definition layer PDL may include a black coloring agent. The black coloring agent may include a black dye or a black pigment. The black coloring agent may include a metal material, such as carbon black, chromium, or an oxide thereof. The pixel definition layer PDL may correspond to a light blocking pattern having a light blocking property.

The pixel definition layer PDL is provided with the opening OP-PDL (hereinafter, referred to as the light emitting opening) defined in the pixel definition layer to expose at least a portion of the first electrode EL1. Multiple light emitting openings OP-PDL may be provided, and the light emitting openings OP-PDL may respectively correspond to the light emitting elements LD. All components of the light emitting element LD may overlap each other in the light emitting opening OP-PDL, and the light emitting opening OP-PDL may correspond to an area where the light emitted from the light emitting element LD is substantially displayed. Accordingly, the shape of the first light emitting portion EP1 (refer to FIG. 4A) may substantially correspond to the shape of the light emitting opening OP-PDL in plan view.

The connection electrode CNE may be disposed on the pixel definition layer PDL. The connection electrode CNE may electrically connect the pixel driving unit PDC and the light emitting element LD. That is, the pixel driving unit PDC may be electrically connected to the light emitting element LD through the intermediate connection electrode CN and the connection electrode CNE. The connection electrode CNE may correspond to the first connection electrode CNE1 shown in FIG. 4A. The second connection electrode CNE2 (refer to FIG. 4A) and the third connection electrode CNE3 (refer to FIG. 4A) may have a structure similar to the connection electrode CNE.

The connection electrode CNE may include a first edge EG1c adjacent to the light emitting opening OP-PDL and a second edge EG2c surrounding the first edge EG1c. A second electrode EL2 of the light emitting element LD may be in contact with the connection electrode CNE in an area adjacent to the second edge EG2c. That is, the second electrode EL2 and the connection electrode CNE may be connected to each other in an area adjacent to the groove GV.

The connection electrode CNE may include a transparent conductive oxide (TCO), such as indium tin oxide (ITO), indium zinc oxide (IZO), indium gallium zinc oxide (IGZO), zinc oxide (ZnO), indium oxide (In₂O₃), or the like, however, the material for the connection electrode CNE should not be limited thereto or thereby.

The connection electrode CNE may have a shape surrounding at least a portion of the light emitting portion EP1 (refer to FIG. 4A) defined in the light emitting element LD. Accordingly, the degree of freedom in designing the position where the connection electrode CNE is connected to the light emitting element LD and the degree of freedom in designing the position where the connection electrode CNE is connected to the pixel driving unit PDC may be improved.

In addition, since the lower surface of the connection electrode CNE is in contact with the upper surface of the intermediate connection electrode CN, the contact reliability may be improved. Thus, the size of the through holes OP-P and OP-60 required to connect the connection electrode CNE and the intermediate connection electrode CN may be reduced. Accordingly, the size and resolution of the light emitting portion of the display panel DP may readily increase.

The groove GV is defined in the pixel definition layer PDL to surround the light emitting opening OP-PDL. The groove GV may be formed by removing a portion of the pixel definition layer PDL in a thickness direction of the pixel definition layer PDL, e.g., the third direction DR3. The groove GV may overlap a gap between two connection electrodes CNE adjacent to each other and disposed on the pixel definition layer PDL.

A portion of the connection electrode CNE may protrude from an end of the groove GV to a center of the groove GV. The portion of the connection electrode CNE may be defined as a tip portion TP. That is, the connection electrode CNE may include the tip portion TP. Since the tip portion TP protrudes to the groove GV, the connection electrode CNE may partially overlap the groove GV in plan view. The second electrode EL2 of the light emitting element LD and the connection electrode CNE may be connected to each other at the tip portion TP or may be in contact with each other at the tip portion TP.

According to an embodiment, the second electrode EL2 and a functional layer FNL may be commonly deposited and formed over the pixels using an open mask. A portion of the functional layer FNL may include an organic layer. In a case where the organic layer is commonly formed, a lateral leakage current may occur due to the organic layer commonly provided over the pixels adjacent to each other, and as a result, a color mixture and a brightness defect may occur between the pixels adjacent to each other. In the disclosure, the expression "lateral leakage current" indicates a current that flows in a direction intersecting the third direction DR3, which corresponds to the stacking direction of the light emitting element, i.e., a direction to which the image is displayed, rather than a current that flows in the third direction DR3. The lateral leakage current may indicate the current flowing in the direction substantially parallel to a plane defined by the first direction DR1 and the second direction DR2.

According to the disclosure, each of an intermediate layer IML and the second electrode EL2 may be divided into portions by the tip portion TP of the connection electrode CNE, and the portions may be respectively disposed in the pixels to prevent the lateral leakage current from occurring between the pixels adjacent to each other. Accordingly, the occurrence of the lateral leakage current may be prevented, and the occurrence of the color mixture between the pixels adjacent to each other and the deterioration of the brightness may be prevented. The tip portion TP of the connection electrode CNE may have a closed line shape with respect to each of the light emitting portions, and thus, each of the second electrode EL2 and the functional layer FNL may be divided into the portions respectively corresponding to the light emitting portions. That is, each of the second electrode EL2 and the intermediate layer IML may be electrically independent between the pixels adjacent to each other.

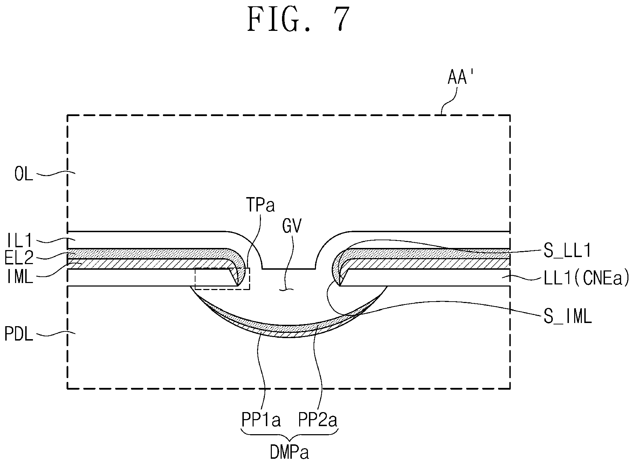

The tip portion TP may have a reverse-tapered shape. That is, a taper angle between the lower surface of the connection electrode CNE and a side surface of the connection electrode CNE may be an obtuse angle, however, this is merely an example. The taper angle may be set in various ways as long as the second electrode EL2 is electrically disconnected by the tip portion TP of the connection electrode CNE in each pixel. As an example, in a case where a connection electrode CNEa (refer to FIG. 7) includes only a first connection electrode layer LL1 (refer to FIG. 7), the taper angle between a lower surface of the connection electrode CNEa and a side surface of the connection electrode CNEa may be an acute angle or a right angle.

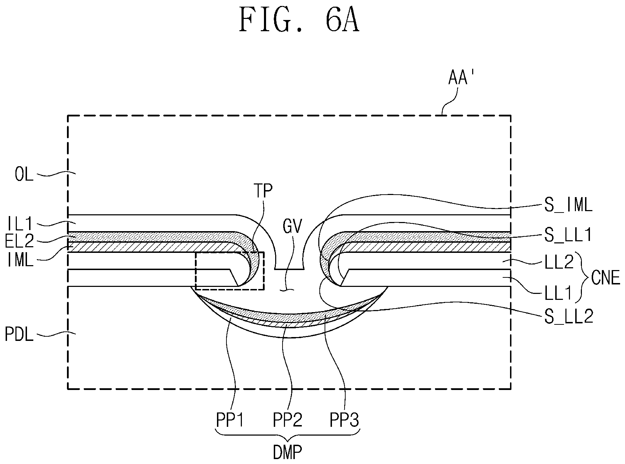

Dummy patterns DMP may be disposed in the groove GV. The dummy patterns DMP may be formed by separating a portion (e.g., a second connection electrode layer LL2 (refer to FIG. 6A)) of the connection electrode CNE, the second electrode EL2, and the functional layer FNL by the tip portion TP of the connection electrode CNE, however, this is merely an example. This will be described in detail with reference to FIGS. 6A to 9.

The through hole OP-P may be defined through the pixel definition layer PDL and may be spaced apart from the light emitting opening OP-PDL. Multiple through holes OP-P may be provided, and the through holes OP-P may be disposed corresponding to the light emitting elements, respectively. The through hole OP-P defined through the pixel definition layer PDL may have a size greater than a size of the through hole OP-60 defined through the sixth insulating layer 60. The connection electrode CNE may be disposed in the through hole OP-P and the through hole OP-60 and may be connected to the intermediate connection electrode CN. That is, the connection electrode CNE may be connected to the pixel driving unit PDC via the through hole OP-P.

The light emitting element LD includes the first electrode EL1, the intermediate layer IML, and the second electrode EL2.

The first electrode EL1 may be a semi-transmissive electrode, a transmissive electrode, or a reflective electrode. According to an embodiment, the first electrode EL1 may include a reflective layer formed of silver (Ag), magnesium (Mg), aluminum (Al), platinum (Pt), palladium (Pd), gold (Au), nickel (Ni), neodymium (Nd), iridium (Ir), chromium (Cr), or compounds thereof and a transparent or semi-transparent electrode layer formed on the reflective layer. The transparent or semi-transparent electrode layer may include at least one selected from the group consisting of indium tin oxide (ITO), indium zinc oxide (IZO), indium gallium zinc oxide (IGZO), zinc oxide (ZnO), indium oxide (In₂O₃), and aluminum-doped zinc oxide (AZO). For instance, the first electrode EL1 may have a stack structure of ITO/Ag/ITO.

In an embodiment, the first electrode EL1 may be the anode of the light emitting element LD. That is, the first electrode EL1 may be connected to the first power line VDL (refer to FIG. 2A) and may receive the first power voltage VDD (refer to FIG. 2A). The first electrode EL1 may be connected to the first power line VDL in the display area DA (refer to FIG. 3A or 3B) or may be connected to the first power line VDL in the peripheral area NDA. In the case where the first electrode EL1 is connected to the first power line VDL in the peripheral area NDA, the first power line VDL may be disposed in the peripheral area NDA(refer to FIG. 3A or 3B), and the first electrode EL1 may extend to the peripheral area NDA.

In the cross-sectional view of FIG. 5, the first electrode EL1 overlaps the light emitting opening OP-PDL and does not overlap the groove GV, however, embodiments should not be limited thereto or thereby. As described with reference to FIG. 4D, the first electrodes EL1 of the light emitting elements may be provided integrally with each other and may have a mesh or lattice shape in which openings are defined in some areas. That is, the first electrode EL1 may have a variety of shapes as long as the light emitting elements receive the same first power voltage VDD through their first electrodes EL1, however, embodiments should not be limited thereto or thereby.

The intermediate layer IML may be disposed between the first electrode EL1 and the second electrode EL2. The intermediate layer IML may include a light emitting layer EML and the functional layer FNL having a size greater than that of the light emitting layer EML. The light emitting element LD may include the intermediate layer IML with various structures and should not be particularly limited. As an example, the functional layer FNL may include layers or may include two or more layers spaced apart from each other with the light emitting layer EML between the two or more layers.

The light emitting layer EML may include an organic light emitting material. According to an embodiment, the light emitting layer EML may include an inorganic light emitting material or may include a layer obtained by mixing the organic light emitting material with the inorganic light emitting material. In an embodiment the light emitting layers EML respectively included in the light emitting portions EP adjacent to each other may include light emitting materials displaying different colors from each other. As an example, the light emitting layer EML included in each light emitting portion EP may emit the light having at least one of blue, red, and green colors, however, embodiments should not be limited thereto or thereby. According to an embodiment, the light emitting layer EML that is commonly disposed in the light emitting portions EP may include a light emitting material displaying the same color. The light emitting layer EML may provide a blue light or a white light.

The functional layer FNL may be disposed between the first electrode EL1 and the second electrode EL2. In detail, the functional layer FNL may include a first intermediate functional layer disposed between the first electrode EL1 and the light emitting layer EML and a second intermediate functional layer disposed between the second electrode EL2 and the light emitting layer EML. According to an embodiment, the first intermediate functional layer or the second intermediate functional layer may be omitted. In an embodiment, the light emitting layer EML may be inserted into the functional layer FNL. That is, the light emitting layer EML may be disposed between the first intermediate functional layer and the second intermediate functional layer.

The functional layer FNL may control a movement of electric charges between the first electrode EL1 and the second electrode EL2. As an example, the first intermediate functional layer may include a hole injection/transport material and/or an electron injection/transport material. The second intermediate functional layer may include at least one of an electron block layer, a hole transport layer, a hole injection layer, a hole block layer, an electron transport layer, an electron injection layer, and an electric charge generating layer.

The second electrode EL2 may be disposed on the intermediate layer IML. As described above, the second electrode EL2 may be electrically connected to the pixel driving unit PDC via the connection electrode CNE. In an embodiment, the second electrode EL2 may be electrically connected to the connection transistor TR via the connection electrode CNE.

The encapsulation layer ECL may be disposed on the light emitting element layer LDL. The encapsulation layer ECL may cover the light emitting element LD and the groove GV. The encapsulation layer ECL may include a first inorganic layer IL1, an organic layer OL, and a second inorganic layer IL2, which are sequentially stacked.

However, the disclosure should not be limited thereto or thereby. According to an embodiment, the encapsulation layer ECL may further include inorganic layers and organic layers. As an example, the encapsulation layer ECL may include a first encapsulation layer instead of the first inorganic layer. The first encapsulation layer may include sub-encapsulation layers. At least one of the sub-encapsulation layers may include an organic material. As an example, the first encapsulation layer may include a first sub-encapsulation layer, a second sub-encapsulation layer, and a third sub-encapsulation layer, the first and third sub-encapsulation layers may include an inorganic material, and the second sub-encapsulation layer may include the organic material. Even though a gap is formed in the first sub-encapsulation layer that is the inorganic material layer, the gap may be filled by the second sub-encapsulation layer. The first encapsulation layer may smoothly cover the groove GV defined in the pixel definition layer PDL and the tip portion TP of the connection electrode CNE. Accordingly, a protective function of the encapsulation layer that protects the light emitting element LD may be improved. However, the disclosure should not be limited thereto or thereby, and the encapsulation layer ECL may be a glass substrate.

The first and second inorganic layers IL1 and IL2 may protect the light emitting element LD from moisture and oxygen outside the display panel DP, and the organic layer OL may protect the light emitting element LD from a foreign substance such as dust particles that remain in a process of forming the first inorganic layer II,1. The first and second inorganic layers IL1 and IL2 may include a silicon nitride layer, a silicon oxynitride layer, a silicon oxide layer, a titanium oxide layer, or an aluminum oxide layer. The organic layer OL may include an acrylic-based organic layer, however, embodiments should not be particularly limited.

The sensing layer ISL may sense external inputs. The sensing layer ISL may be formed on the encapsulation layer ECL through successive processes. The sensing layer ISL may be disposed directly on the encapsulation layer ECL. In the disclosure, the expression "The sensing layer ISL is disposed directly on the encapsulation layer ECL." means that no intervening elements are present between the sensing layer ISL and the encapsulation layer ECL. That is, a separate adhesive member need not be disposed between the sensing layer ISL and the encapsulation layer ECL, however, this is merely an example. According to an embodiment, the sensing layer ISL may be provided after being separately formed and may be coupled to the display panel DP by an adhesive member, and embodiments should not be limited thereto or thereby.

The sensing layer ISL may include conductive layers and insulating layers. The conductive layers may include a first sensing conductive layer MTL1 and a second sensing conductive layer MTL2, and the insulating layers may include first, second, and third sensing insulating layers 71, 72, and 73. However, this is merely an example, and the number of insulating layers should not be particularly limited.

Each of the first, second, and third sensing insulating layers 71, 72, and 73 may have a single-layer structure or a multi-layer structure of layers stacked in the third direction DR3. The first, second, and third sensing insulating layers 71, 72, and 73 may include an inorganic layer. The inorganic layer may include at least one of aluminum oxide, titanium oxide, silicon oxide, silicon nitride, silicon oxynitride, zirconium oxide, and hafnium oxide. The first, second, and third sensing insulating layers 71, 72, and 73 may include an organic layer. The organic layer may include at least one of an acrylic-based resin, a methacrylic-based resin, a polyisoprene-based resin, a vinyl-based resin, an epoxy-based resin, a urethane-based resin, a cellulose-based resin, a siloxane-based resin, a polyimide-based resin, a polyamide-based resin, and a perylene-based resin.

The first sensing conductive layer MTL1 may be disposed between the first sensing insulating layer 71 and the second sensing insulating layer 72, and the second sensing conductive layer MTL2 may be disposed between the second sensing insulating layer 72 and the third sensing insulating layer 73. A portion of the second sensing conductive layer MTL2 may be connected to the first sensing conductive layer MTL1 via a contact hole CNT formed through the second sensing insulating layer 72. Each of the first and second sensing conductive layers MTL1 and MTL2 may have a single-layer structure or a multi-layer structure of layers stacked in the third direction DR3.

The sensing conductive layer having the single-layer structure may include a metal layer or a transparent conductive layer. The metal layer may include molybdenum, silver, titanium, copper, aluminum, or alloys thereof. The transparent conductive layer may include a transparent conductive oxide, such as indium tin oxide (ITO), indium zinc oxide (IZO), zinc oxide (ZnO), indium zinc tin oxide (IZTO), or the like. In addition, the transparent conductive layer may include conductive polymer such as PEDOT, metal nanowire, graphene, or the like.

The sensing conductive layer having the multi-layer structure may include metal layers. The metal layers may have a three-layer structure of titanium(Ti)/aluminum(Al)/titanium(Ti). The sensing conductive layer having the multi-layer structure may include at least one metal layer and at least one transparent conductive layer.

The first sensing conductive layer MTL1 and the second sensing conductive layer MTL2 may form a sensor to sense the external inputs in the sensing layer ISL. The sensor may be driven in a capacitive method, e.g., a mutual capacitive method or a self-capacitive method, however, this is merely an example. According to an embodiment, the sensor may be driven in a resistive film method, an ultrasonic method, or an infrared method rather than the capacitive method, and embodiments should not be particularly limited.

Each of the first sensing conductive layer MTL1 and the second sensing conductive layer MTL2 may include a transparent conductive oxide or may have a metal mesh shape formed of an opaque conductive material. The first sensing conductive layer MTL1 and the second sensing conductive layer MTL2 may include various materials and various shapes as long as a visibility of the image displayed by the display panel DP is not deteriorated.

FIG. 6A is an enlarged schematic cross-sectional view of an area of the display panel according to an embodiment of the disclosure. FIG. 6A is an enlarged cross-sectional view of an area AA' of FIG. 5.

Referring to FIGS. 5 and 6A, the connection electrode CNE may include the first connection electrode layer LL1 disposed on the pixel definition layer PDL and the second connection electrode layer LL2 disposed on the first connection electrode layer LL1. The second connection electrode layer LL2 may cover the first connection electrode layer LL1. As an example, the second connection electrode layer LL2 may cover an upper surface and a side surface S_LL1 of the of the first connection electrode layer LL1. Accordingly, the side surface S_LL1 of the first connection electrode layer LL1 need not be exposed to the outside. An end of the first connection electrode layer LL1 and an end of the second connection electrode layer LL2, which covers the end of the first connection electrode layer LL1, may form the tip portion TP of the connection electrode CNE.

The second connection electrode layer LL2 may be patterned by or on the end of the first connection electrode layer LL1, and a portion of the second connection electrode layer LL2 may be disposed in the groove GV. As the second connection electrode layer LL2 is disposed and patterned on the first connection electrode layer LL1, the connection electrode CNE may have a reverse-tapered shape. As an example, a taper angle between a lower surface of the first connection electrode layer LL1 and the side surface S_LL1 of the first connection electrode layer LL1 may be an acute or right angle. As the second connection electrode layer LL2 is patterned by or on the protruded end of the first connection electrode layer LL1, the second connection electrode layer LL2 may smoothly cover the side surface S_LL1 of the first connection electrode layer LL1, and the tip portion TP of the connection electrode CNE may have a reverse-tapered shape.

The first connection electrode layer LL1 and the second connection electrode layer LL2 may include a transparent conductive oxide (TCO), such as indium tin oxide (ITO), indium zinc oxide (IZO), indium gallium zinc oxide (IGZO), zinc oxide (ZnO), indium oxide (In₂O₃), or the like, however, the material for the first connection electrode layer LL1 and the second connection electrode layer LL2 should not be limited thereto or thereby.

The intermediate layer IML may be disposed on the second connection electrode layer LL2. The intermediate layer IML may cover an upper surface and a portion of a side surface S_LL2 of the second connection electrode layer LL2. The intermediate layer IML may be patterned by or on the tip portion TP of the connection electrode CNE, and a portion of the intermediate layer IML may be disposed in the groove GV.

The second electrode EL2 is disposed on the intermediate layer IML. The second electrode EL2 may cover an upper surface and a side surface S_IML of the intermediate layer IML. The second electrode EL2 may be patterned by or on the tip portion TP of the connection electrode CNE, and a portion of the second electrode EL2 may be disposed in the groove GV. The second electrode EL2 may be connected to or may be in contact with the second connection electrode layer LL2. As an example, an end of the second electrode EL2 and a portion of the end of the second connection electrode layer LL2, which is not covered by the intermediate layer IML, may be connected to or may be in contact with each other at the tip portion TP of the connection electrode CNE.

The dummy patterns DMP may be disposed in the groove GV. The dummy patterns DMP may include a first partition pattern PP1, a second partition pattern PP2, and a third partition pattern PP3.

The first partition pattern PP1 may include the same material as the second connection electrode layer LL2. The first partition pattern PP1 may be substantially simultaneously formed through a single process as the second connection electrode layer LL2 and may be separated from the second connection electrode layer LL2 by the end of the first connection electrode layer LL1.

The second partition pattern PP2 may include the same material as the intermediate layer IML. The second partition pattern PP2 may be substantially simultaneously formed through a single process as the intermediate layer IML and may be separated from the intermediate layer IML by the tip portion TP of the connection electrode CNE.

The third partition pattern PP3 may include the same material as the second electrode EL2. The third partition pattern PP3 may be substantially simultaneously formed through a single process as the second electrode EL2 and may be separated from the second electrode EL2 by the tip portion TP of the connection electrode CNE. The first partition pattern PP1 may be electrically connected to the third partition pattern PP3 in the groove GV.

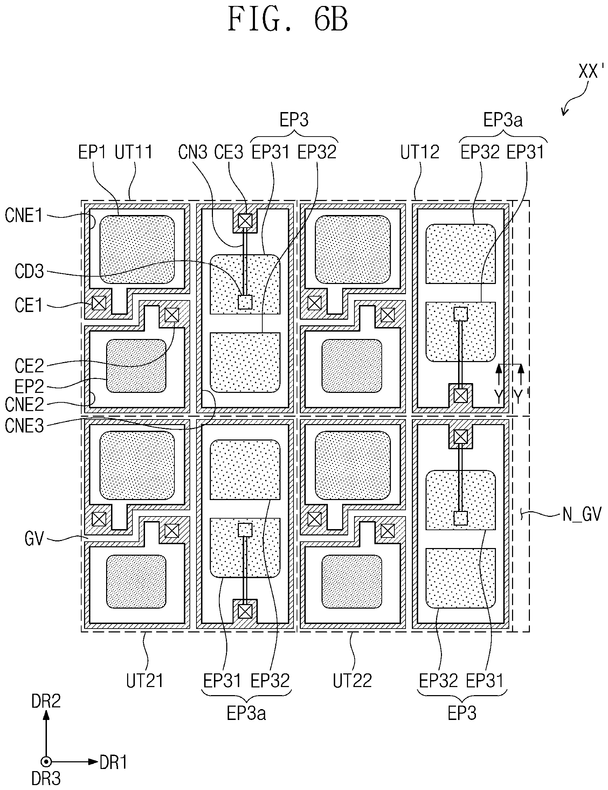

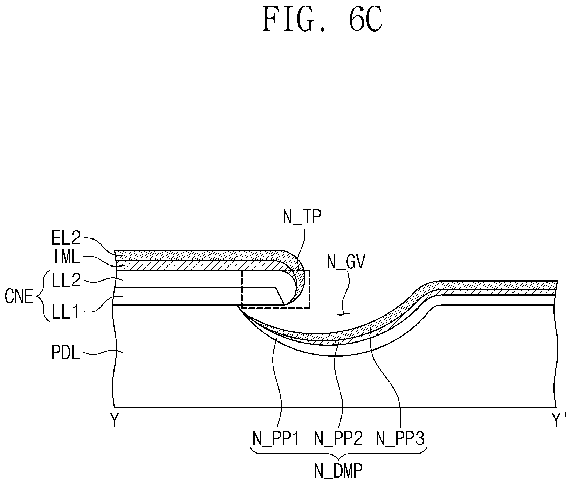

FIG. 6B is an enlarged schematic plan view of an area of the display panel DP (refer to FIG. 3A) according to an embodiment of the disclosure, and FIG. 6C is an enlarged schematic cross-sectional view of an area of the display panel DP (refer to FIG. 3A) according to an embodiment of the disclosure. FIG. 6B is an enlarged plan view of an area XX' of FIG. 3A, and FIG. 6C is an enlarged schematic cross-sectional view taken along a line Y-Y' of FIG. 6B. FIGS. 6B and 6C show an outer portion of the display panel DP.

Referring to FIGS. 6A to 6C, the connection electrode CNE need not be disposed at a boundary between the display area DA (refer to FIG. 3A) and the non-display area NDA (refer to FIG. 3A) of the display panel DP. That is, a portion of the tip portion TP of the connection electrode CNE need not be formed in the outer portion of the display panel DP. As an example, a tip portion N_TP (hereinafter, referred to as an outer tip portion) of the connection electrode CNE formed in the outer portion of the display panel DP may be formed adjacent to the areas in which the light emitting portions EP1, EP2, and EP3 are disposed and need not be formed in areas in which the light emitting portions EP1, EP2, and EP3 are not disposed. An outer groove N_GV may be formed in an area in which the outer tip portion N_TP is not formed. The outer groove N_GV may be formed along the boundary between the display area DA and the non-display area NDA. The outer groove N_GV may have a shape connected to the groove GV formed between the light emitting portions EP1, EP2, and EP3.

Outer dummy patterns N_DMP may be disposed in the outer groove N_GV. The outer dummy patterns N_DMP may include a first outer partition pattern N_PP1, a second outer partition pattern N_PP2, and a third outer partition pattern N_PP3.

The first outer partition pattern N_PP1 may include the same material as the second connection electrode layer LL2. The first outer partition pattern N_PP1 may be substantially simultaneously formed with the second connection electrode layer LL2 through a single process and may be separated from the second connection electrode layer LL2 by the end of the first connection electrode layer LL1. The first outer partition pattern N_PP1 may be connected to and may be provided integrally with the first partition pattern PP1.

The second outer partition pattern N_PP2 may include the same material as the intermediate layer IML. The second outer partition pattern N_PP2 may be substantially simultaneously formed with the intermediate layer IML through a single process and may be separated from the intermediate layer IML by the outer tip portion N_TP of the connection electrode CNE. The second outer partition pattern N_PP2 may be connected to and may be provided integrally with the second partition pattern PP2.

The third outer partition pattern N_PP3 may include the same material as the second electrode EL2. The third outer partition pattern N_PP3 may be substantially simultaneously formed with the second electrode EL2 through a single process and may be separated from the second electrode EL2 by the outer tip portion N_TP of the connection electrode CNE. The third outer partition pattern N_PP3 may be connected to and may be provided integrally with the third partition pattern PP3.

The first power voltage VDD that is a constant voltage may be applied to the third outer partition pattern N_PP3. The first outer partition pattern N_PP1 may be electrically connected to the third outer partition pattern N_PP3 in the outer groove N_GV, and thus, the first power voltage VDD may be applied to the first outer partition pattern N_PP1. Since the outer groove N_GV has the shape connected to the groove GV formed between the light emitting portions EP1, EP2, and EP3, the first power voltage VDD may be applied to the first partition pattern PP1 and the third partition pattern PP3 disposed in the groove GV.

According to an embodiment, as the first power voltage VDD that is the constant voltage is applied to the first partition pattern PP1 and the first outer partition pattern N_PP1, noise coupling caused by the first partition pattern PP1 and the first outer partition pattern N_PP1 may be reduced or removed.

FIG. 7 is an enlarged schematic cross-sectional view of an area of a display panel according to an embodiment of the disclosure. FIG. 7 is an enlarged cross-sectional view of an area AA' of FIG. 5. In FIG. 7, the same/similar reference numerals denote the same/similar elements in FIGS. 1 to 6C, and thus, detailed descriptions of the same elements will be omitted.

Referring to FIGS. 5 and 7, a connection electrode CNEa is disposed on a pixel definition layer PDL. The connection electrode CNEa is electrically connected to a pixel driving unit PDC and a light emitting element LD. The connection electrode CNEa may include a first connection electrode layer LL1 disposed on the pixel definition layer PDL. That is, the connection electrode CNEa may have a structure obtained by excluding the second connection electrode layer LL2 (refer to FIG. 6A) from the connection electrode CNE of FIG. 6A. An end of the first connection electrode layer LL1 may form a tip portion TPa of the connection electrode CNEa. A taper angle between a lower surface of the connection electrode CNEa and a side surface of the connection electrode CNEa may be an acute or right angle. However, the disclosure should not be limited thereto or thereby, and the tip portion TPa may have a reverse-tapered shape.

An intermediate layer IML is disposed on the first connection electrode layer LL1. The intermediate layer IML may cover an upper surface and a portion of a side surface S_LL1 of the first connection electrode layer LL1. The intermediate layer IML may be patterned by or on the tip portion TPa of the connection electrode CNEa, and a portion of the intermediate layer IML may be disposed in a groove GV.

A second electrode EL2 may be disposed on the intermediate layer IML. The second electrode EL2 may cover an upper surface and a side surface S_IML of the intermediate layer IML. The second electrode EL2 may be patterned by or on the tip portion TPa of the connection electrode CNEa, and a portion of the second electrode EL2 may be disposed in the groove GV. The second electrode EL2 may be connected to or may be in contact with the first connection electrode layer LL1. As an example, an end of the second electrode EL2 may be connected to or may be in contact with a portion of the end of the first connection electrode layer LL1, which is not covered by the intermediate layer IML, at the tip portion TPa of the connection electrode CNEa.

Dummy patterns DMPa may be disposed in the groove GV. The dummy patterns DMPa may include a first partition pattern PP1a and a second partition pattern PP2a.

The first partition pattern PP1a may include the same material as the intermediate layer IML. The first partition pattern PP1a may be substantially simultaneously formed with the intermediate layer IML through a single process and may be separated from the intermediate layer IML by the tip portion TPa of the connection electrode CNEa.

The second partition pattern PP2a may include the same material as the second electrode EL2. The second partition pattern PP2a may be substantially simultaneously formed with the second electrode EL2 through a single process and may be separated from the second electrode EL2 by the tip portion TPa of the connection electrode CNEa.

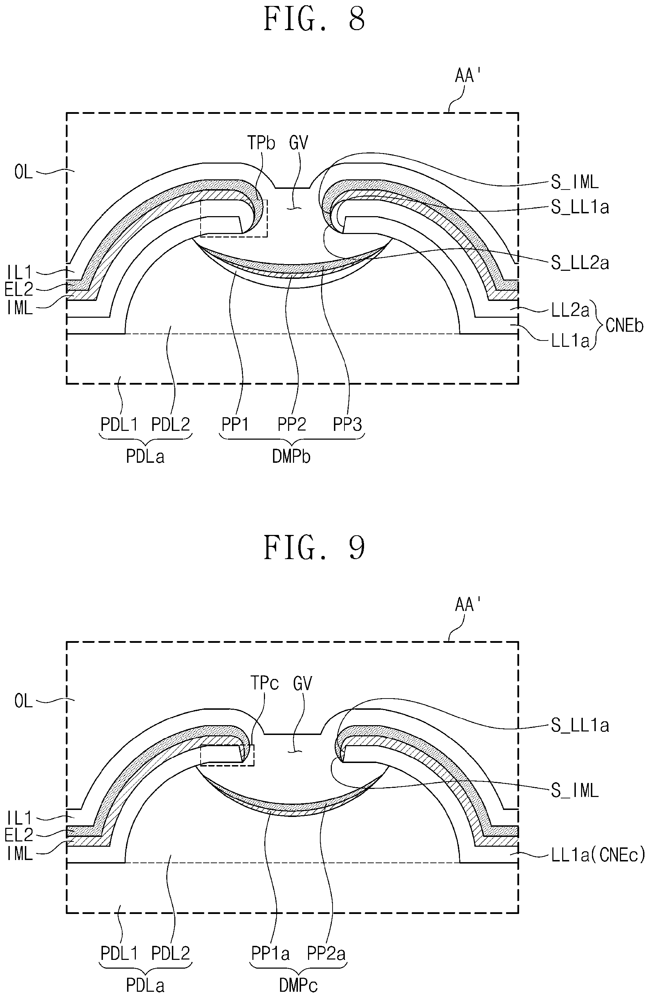

FIG. 8 is an enlarged schematic cross-sectional view of an area of a display panel according to an embodiment of the disclosure. FIG. 8 is an enlarged cross-sectional view of an area AA' of FIG. 5. In FIG. 8, the same/similar reference numerals denote the same/similar elements in FIGS. 1 to 7, and thus, detailed descriptions of the same elements will be omitted.

Referring to FIGS. 5 and 8, a pixel definition layer PDLa may include a first pixel definition layer portion PDL1 and a second pixel definition layer portion PDL2. The first pixel definition layer portion PDL1 and the second pixel definition layer portion PDL2 may be formed through a single process and may have a single body. The first pixel definition layer portion PDL1 may be disposed on a sixth insulating layer 60, and the second pixel definition layer portion PDL2 may be disposed on the first pixel definition layer portion PDL1. The first pixel definition layer portion PDL1 may correspond to the pixel definition layer PDL of FIG. 6A. The second pixel definition layer portion PDL2 may have a shape that protrudes in a thickness direction, e.g., the third direction DR3, from the first pixel definition layer portion PDL1. A groove GV may be defined in the second pixel definition layer portion PDL2.

A connection electrode CNEb is disposed on the pixel definition layer PDLa. The connection electrode CNEb may electrically connect a pixel driving unit PDC and a light emitting element LD. The connection electrode CNEb may include a first connection electrode layer LL1a disposed on the pixel definition layer PDLa and a second connection electrode layer LL2a disposed on the first connection electrode layer LL1a. The second connection electrode layer LL2a may cover the first connection electrode layer LL1a. As an example, the second connection electrode layer LL2a may cover an upper surface and a side surface S_LL1a of the first connection electrode layer LL1a. Accordingly, the side surface S_LL1a of the first connection electrode layer LL1a need not be exposed to the outside. An end of the first connection electrode layer LL1a and an end of the second connection electrode layer LL2a covering the end of the first connection electrode layer LL1a may form a tip portion TPb of the connection electrode CNEb.

The second connection electrode layer LL2a may be patterned by or on the end of the first connection electrode layer LL1a, and a portion of the second connection electrode layer LL2a may be disposed in the groove GV. As the second connection electrode layer LL2a is disposed and patterned on the first connection electrode layer LL1a, the connection electrode CNEb may have a reverse-tapered shape. As an example, a taper angle between a lower surface of the first connection electrode layer LL1a and the side surface S_LL1a of the first connection electrode layer LL1a may be an acute or right angle. As the second connection electrode layer LL2a is patterned by or on the end of the first connection electrode layer LL1a, which is protruded, the second connection electrode layer LL2a may smoothly cover the side surface S_LL1a of the first connection electrode layer LL1a, and the tip portion TPb of the connection electrode CNEb may have the reverse-tapered shape. In addition, as the pixel definition layer PDLa includes the second pixel definition layer portion PDL2 protruded from the first pixel definition layer portion PDL1, the tip portion TPb of the connection electrode CNEb may have the reverse-tapered shape by a slope of the second pixel definition layer portion PDL2.

The first connection electrode layer LL1a and the second connection electrode layer LL2a may include a transparent conductive oxide (TCO), such as indium tin oxide (ITO), indium zinc oxide (IZO), indium gallium zinc oxide (IGZO), zinc oxide (ZnO), indium oxide (In₂O₃), or the like, however, the material for the first connection electrode layer LL1a and the second connection electrode layer LL2a should not be limited thereto or thereby.

An intermediate layer IML may be disposed on the second connection electrode layer LL2a. The intermediate layer IML may cover an upper surface and a portion of a side surface S_LL2a of the second connection electrode layer LL2a. The intermediate layer IML may be patterned by or on the tip portion TPb of the connection electrode CNEb, and a portion of the intermediate layer IML may be disposed in the groove GV.

A second electrode EL2 may be disposed on the intermediate layer IML. The second electrode EL2 may cover an upper surface and a side surface S_IML of the intermediate layer IML. The second electrode EL2 may be patterned by or on the tip portion TPb of the connection electrode CNEb, and a portion of the second electrode EL2 may be disposed in the groove GV. The second electrode EL2 may be connected to or may be in contact with the second connection electrode layer LL2a. As an example, an end of the second electrode EL2 may be connected to or may be in contact with a portion of the end of the second connection electrode layer LL2a, which is not covered by the intermediate layer IML, at the tip portion TPb of the connection electrode CNEb.

Dummy patterns DMPb may be disposed in the groove GV. Dummy patterns DMPb may include a first partition pattern PP1, a second partition pattern PP2, and a third partition pattern PP3. The first partition pattern PP1, the second partition pattern PP2, and the third partition pattern PP3 may be substantially the same as the first partition pattern PP1, the second partition pattern PP2, and the third partition pattern PP3 of FIG. 6A, respectively.

FIG. 9 is an enlarged schematic cross-sectional view of an area of a display panel according to an embodiment of the disclosure. FIG. 9 is an enlarged cross-sectional view of an area AA' of FIG. 5. In FIG. 9, the same/similar reference numerals denote the same/similar elements in FIGS. 1 to 8, and thus, detailed descriptions of the same elements will be omitted.

Referring to FIGS. 5 and 9, a pixel definition layer PDLa may include a first pixel definition layer portion PDL1 and a second pixel definition layer portion PDL2. A connection electrode CNEc is disposed on the pixel definition layer PDLa. The connection electrode CNEc may electrically connect a pixel driving unit PDC and a light emitting element LD. The connection electrode CNEc may include a first connection electrode layer LL1a disposed on the pixel definition layer PDLa. That is, the connection electrode CNEc may have a structure obtained by omitting the second connection electrode layer LL2a (refer to FIG. 8) from the connection electrode CNEb of FIG. 8. An end of the first connection electrode layer LL1a may form a tip portion TPc of the connection electrode CNEc. A taper angle between a lower surface and a side surface of the of the connection electrode CNEc may be an acute or right angle, however, the disclosure should not be limited thereto or thereby. According to an embodiment, the tip portion TPc may have a reverse-tapered shape. As an example, as the pixel definition layer PDLa includes the second pixel definition layer portion PDL2 that protrudes from the first pixel definition layer portion PDL1, the tip portion TPc of the connection electrode CNEc may have a reverse-tapered shape by a slope of the second pixel definition layer portion PDL2.

An intermediate layer IML may be disposed on the first connection electrode layer LL1a. The intermediate layer IML may cover an upper surface and a side surface S_LL1a of the first connection electrode layer LL1a. The intermediate layer IML may be patterned by or on the tip portion TPc of the connection electrode CNEc, and a portion of the intermediate layer IML may be disposed in a groove GV.

A second electrode EL2 is disposed on the intermediate layer IML. The second electrode EL2 may cover an upper surface and a side surface S_IML of the intermediate layer IML. The second electrode EL2 may be patterned by or on the tip portion TPc of the connection electrode CNEc, and a portion of the second electrode EL2 may be disposed in the groove GV. The second electrode EL2 may be connected to or may be in contact with the first connection electrode layer LL1a. As an example, an end of the second electrode EL2 may be connected to or may be in contact with a portion of the end of the first connection electrode layer LL1a, which is not covered by the intermediate layer IML, at the tip portion TPc of the connection electrode CNEc.

Dummy patterns DMPc may be disposed in the groove GV. The dummy patterns DMPc may include a first partition pattern PP1a and a second partition pattern PP2a. The first partition pattern PP1a and the second partition pattern PP2a may be substantially the same as the first partition pattern PP1a and the second partition pattern PP2a of FIG. 7, respectively.

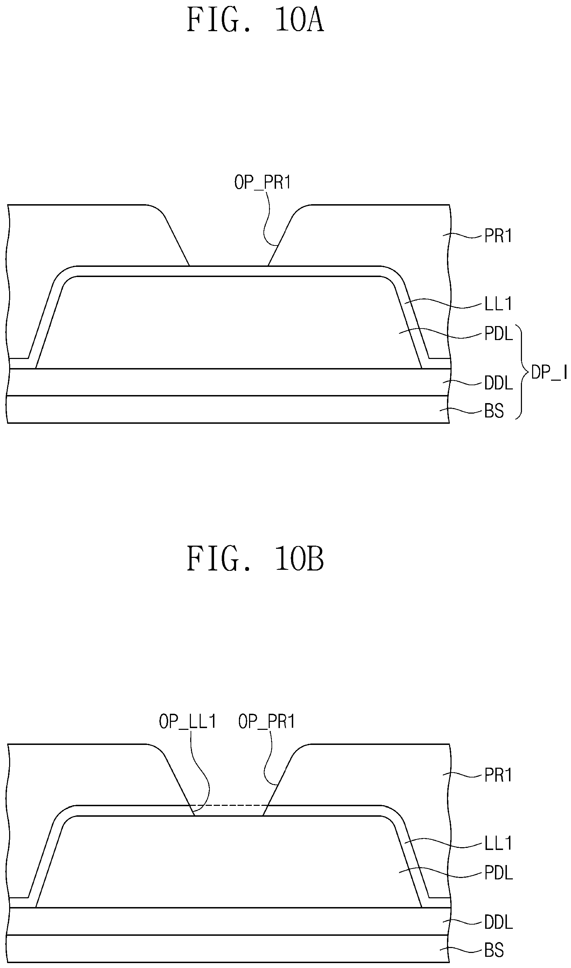

FIGS. 10A to 10F are schematic cross-sectional views illustrating processes of a method of manufacturing the display panel according to an embodiment of the disclosure. In FIGS. 10A to 10F, the same/similar reference numerals denote the same/similar elements in FIGS. 1 to 6C, and thus, detailed descriptions of the same elements will be omitted. The display panel manufactured by the manufacturing method shown in FIGS. 10A to 10F may correspond to the display panel shown in FIG. 6A.

According to the disclosure, the manufacturing method of the display panel includes preparing a preliminary display panel including the base layer, the driving element layer disposed on the base layer, and the pixel definition layer disposed on the driving element layer, depositing the first connection electrode layer on the preliminary display panel, etching a portion of the first connection electrode layer and a portion of the pixel definition layer to form the groove overlapping a portion of the first connection electrode layer in the pixel definition layer, etching the first connection electrode layer to form the connection electrode, and forming the intermediate layer and the cathode on the connection electrode and the pixel definition layer.

Referring to FIG. 10A, the manufacturing method of the display panel may include preparing the preliminary display panel DP_I and depositing the first connection electrode layer LL1. The preliminary display panel DP_I includes the base layer BS, the driving element layer DDL disposed on the base layer BS, and the pixel definition layer PDL disposed on the driving element layer DDL.

The base layer BS may provide a base surface on which the pixel driving unit PDC (refer to FIG. 5) is disposed. The driving element layer DDL may be formed through a conventional manufacturing process of a circuit element in which insulating layers, conductive layers, and semiconductor layers are formed through coating and deposition processes and the insulating layers, the semiconductor layers, and the conductive layers are selectively patterned through photolithography and etching processes to form the semiconductor pattern, the conductive pattern, and the signal line. The driving element layer DDL may include the first, second, third, fourth, fifth, and sixth insulating layer 10, 20, 30, 40, 50, and 60 (refer to FIG. 5) and the pixel driving unit PDC, which are sequentially stacked on the base layer BS.

The pixel definition layer PDL is formed on the driving element layer DDL. The pixel definition layer PDL through which the light emitting opening OP-PDL (refer to FIG. 5) and the through hole OP-P (refer to FIG. 5) are defined may be formed by depositing a preliminary pixel definition layer on the driving element layer DDL and selectively patterning the preliminary pixel definition layer using photolithography and etching processes.

The first connection electrode layer LL1 is deposited on the preliminary display panel DP_I. The depositing of the first connection electrode layer LL1 may be performed by a process of depositing a conductive material. The conductive material used to form the first connection electrode layer LL1 may include the transparent conductive oxide (TCO), such as indium tin oxide (ITO), indium zinc oxide (IZO), indium gallium zinc oxide (IGZO), zinc oxide (ZnO), indium oxide (In₂O₃), or the like, however, the material for the first connection electrode layer LL1 should not be limited thereto or thereby.

The manufacturing method of the display panel may include forming a first photoresist layer PR1. The first photoresist layer PR1 may be formed on the first connection electrode layer LL1. The first photoresist layer PR1 may be formed by forming a preliminary photoresist layer on the first connection electrode layer LL1 and patterning the preliminary photoresist layer using a photomask. Through the patterning process, the first photoresist layer PR1 through which a first photo opening OP_PR1 is defined may be formed.

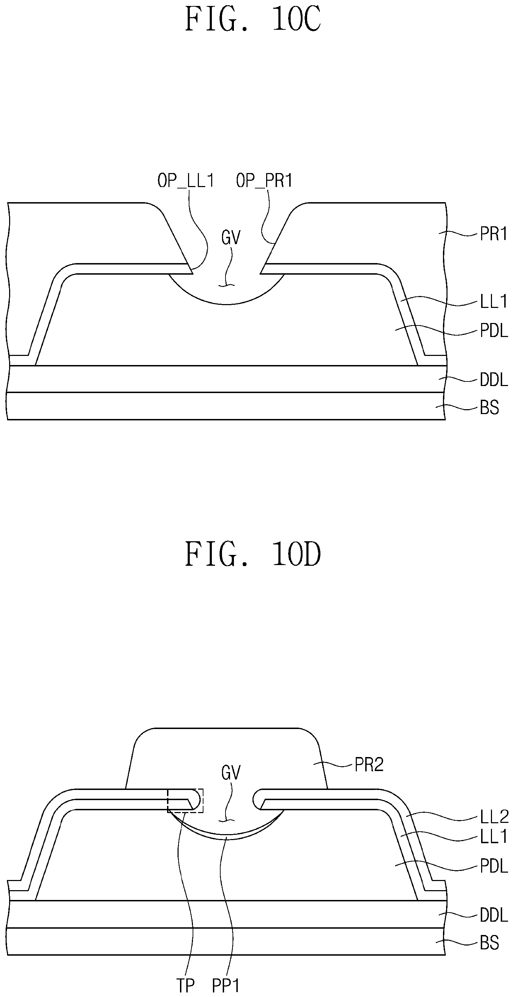

Referring to FIGS. 10B and 10C, the manufacturing method of the display panel may include forming the groove GV of the pixel definition layer PDL, which overlaps the portion of the first connection electrode layer LL1.

Referring to FIG. 10B, the forming of the groove GV of the pixel definition layer PDL includes etching the portion of the first connection electrode layer LL1. The etching process for the first connection electrode layer LL1 may be a wet etching process. The portion of the first connection electrode layer LL1 may be removed by the wet etching process, and thus, a first opening OP_LL1 may be formed through the first connection electrode layer LL1. The first opening OP _LL1 may overlap the first photo opening OP_PR1 of the first photoresist layer PR1. The end of the first connection electrode layer LL1 that defines the first opening OP_LL1 may have the tapered shape. As an example, the taper angle between the lower surface of the first connection electrode layer LL1 and the side surface of the first connection electrode layer LL1 may be an acute or right angle, however, embodiments should not be limited thereto or thereby.

Referring to FIG. 10C, the forming of the groove GV of the pixel definition layer PDL includes etching a portion of the pixel definition layer PDL. The etching process for the pixel definition layer PDL may be a dry etching process. The portion of the pixel definition layer PDL may be removed by the dry etching process, and the groove GV may be formed in the pixel definition layer PDL. The groove GV may overlap the first opening OP _LL1 of the first connection electrode layer LL1 and the first photo opening OP _PR1 of the first photoresist layer PR1. The groove GV may overlap a portion of the first connection electrode layer LL1. That is, the portion of the first connection electrode layer LL1 may protrude from the end of the groove GV to a center of the groove GV.

Referring to FIG. 10D, the manufacturing method of the display panel may include removing the first photoresist layer PR1 (refer to FIG. 10C), depositing the second connection electrode layer LL2, and forming the tip portion TP.

The second connection electrode layer LL2 may be deposited on the first connection electrode layer LL1. The depositing of the second connection electrode layer LL2 may be performed by a process of depositing a conductive material. The conductive material used to form the second connection electrode layer LL2 may include the transparent conductive oxide (TCO), such as indium tin oxide (ITO), indium zinc oxide (IZO), indium gallium zinc oxide (IGZO), zinc oxide (ZnO), indium oxide (In₂O₃), or the like, however, the material for the second connection electrode layer LL2 should not be limited thereto or thereby. The tip portion TP may be defined by the end of the first connection electrode layer LL1 and the end of the second connection electrode layer LL2 that covers the end of the first connection electrode layer LL1.

The second connection electrode layer LL2 may be patterned by or on the end of the first connection electrode layer LL1, and the portion of the second connection electrode layer LL2 may be disposed in the groove GV. The portion of the second connection electrode layer LL2, which is separated from the second connection electrode layer LL2 by the end of the first connection electrode layer LL1, may be defined as the first partition pattern PP1. The first partition pattern PP1 may include the same material as the second connection electrode layer LL2, and the first partition pattern PP1 may be substantially simultaneously formed with the second connection electrode layer LL2 through a single process.

The manufacturing method of the display panel may include forming a second photoresist layer PR2. The second photoresist layer PR2 may be formed on the second connection electrode layer LL2. The second photoresist layer PR2 may be formed by forming a preliminary photoresist layer on the second connection electrode layer LL2 and patterning the preliminary photoresist layer using a photomask. Through the patterning process, the second photoresist layer PR2 may be formed and may overlap the groove GV.

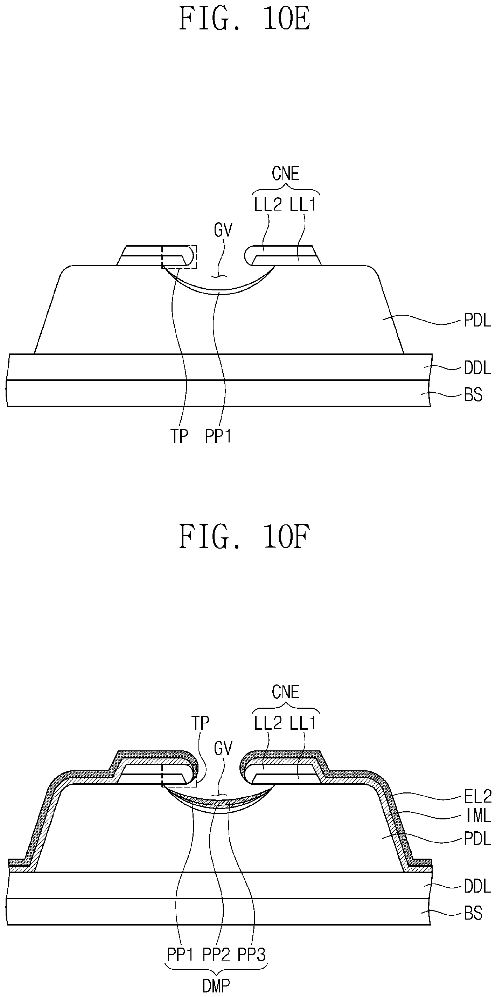

Referring to FIG. 10E, the manufacturing method of the display panel may include etching the first connection electrode layer LL1 and the second connection electrode layer LL2 to form the connection electrode CNE. The etching process for the first connection electrode layer LL1 and the second connection electrode layer LL2 may be a wet etching. A portion of the first connection electrode layer LL1 and a portion of the second connection electrode layer LL2, which do not overlap the second photoresist layer PR2 (refer to FIG. 10D), may be etched and removed. The first connection electrode layer LL1 and the second connection electrode layer LL2, which remain and overlap the second photoresist layer PR2, may form the connection electrode CNE. The second photoresist layer PR2 may be removed.

Referring to FIG. 10F, the manufacturing method of the display panel includes forming the intermediate layer IML and the second electrode EL2 (or the cathode) on the connection electrode CNE and the pixel definition layer PDL. The forming of the intermediate layer IML and the forming of the second electrode EL2 may be performed by a deposition process.

The intermediate layer IML may be patterned by or on the tip portion TP of the connection electrode CNE, and the portion of the intermediate layer IML may be disposed in the groove GV. The portion of the intermediate layer IML, which is separated from the intermediate layer IML by the tip portion TP of the connection electrode CNE, may be defined as the second partition pattern PP2. The second partition pattern PP2 may include the same material as the intermediate layer IML, and the second partition pattern PP2 may be substantially simultaneously formed with the intermediate layer IML through a single process.

The second electrode EL2 may be patterned by or on the tip portion TP of the connection electrode CNE, and the portion of the second electrode EL2 may be disposed in the groove GV. The portion of the second electrode EL2, which is separated from the second electrode EL2 by the tip portion TP of the connection electrode CNE, may be defined as the third partition pattern PP3. The third partition pattern PP3 may include the same material as the second electrode EL2, and the third partition pattern PP3 may be substantially simultaneously formed with the second electrode EL2 through a single process. The first partition pattern PP1, the second partition pattern PP2, and the third partition pattern PP3 may form the dummy patterns DMP.

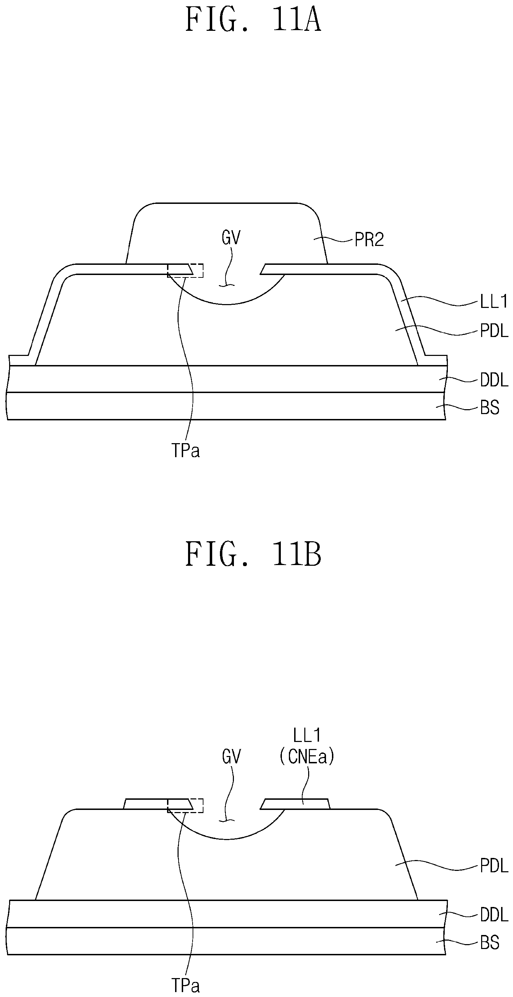

FIGS. 11A to 11C are schematic cross-sectional views illustrating processes of a manufacturing method of the display panel according to an embodiment of the disclosure. In FIGS. 11A to 11C, the same/similar reference numerals denote the same/similar elements in FIGS. 1 to 10F, and thus, detailed descriptions of the same elements will be omitted. The display panel manufactured by the manufacturing method shown in FIGS. 11A to 11C may correspond to the display panel shown in FIG. 7.

The manufacturing method of the display panel may include preparing the preliminary display panel DP_I (refer to FIG. 10A), depositing the first connection electrode layer LL1, and forming the groove GV of the pixel definition layer PDL to overlap the portion of the first connection electrode layer LL1. The preparing of the preliminary display panel DP_I (refer to FIG. 10A), the depositing of the first connection electrode layer LL1, and the forming of the groove GV of the pixel definition layer PDL, which overlaps the portion of the first connection electrode layer LL1, may be substantially the same as those of FIGS. 10A to 10C.

Referring to FIG. 11A, the manufacturing method of the display panel may include forming the tip portion TPa and forming the second photoresist layer PR2 after removing the first photoresist layer PR1 (refer to FIG. 10C). The tip portion TPa may be defined by the end of the first connection electrode layer LL1.

The second photoresist layer PR2 may be disposed on the first connection electrode layer LL1. The second photoresist layer PR2 may be formed by forming a preliminary photoresist layer on the first connection electrode layer LL1 and pattering the preliminary photoresist layer using a photomask. Through the patterning process, the second photoresist layer PR2 that overlaps the groove GV may be formed.

Referring to FIG. 11B, the manufacturing method of the display panel includes etching the first connection electrode layer LL1 to form the connection electrode CNEa. The etching process for the first connection electrode layer LL1 may be a wet etching process. The portion of the first connection electrode layer LL1, which does not overlap the second photoresist layer PR2 (refer to FIG. 11A), may be etched and removed, and the first connection electrode layer LL1 that remains and overlaps the second photoresist layer PR2 may form the connection electrode CNEa. The second photoresist layer PR2 may be removed.

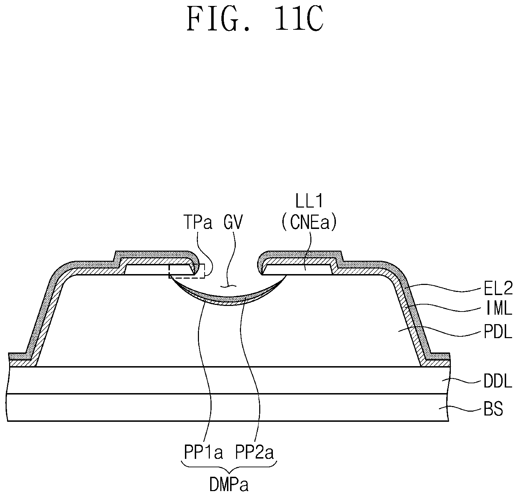

Referring to FIG. 11C, the manufacturing method of the display panel may include forming the intermediate layer IML and the second electrode EL2 (or the cathode) on the connection electrode CNEa and the pixel definition layer PDL. The forming of the intermediate layer IML and the forming of the second electrode EL2 may be performed by a deposition process.

The intermediate layer IML may be patterned by or on the tip portion TPa of the connection electrode CNEa, and the portion of the intermediate layer IML may be disposed in the groove GV. The portion of the intermediate layer IML, which is separated from the intermediate layer IML by the tip portion TPa of the connection electrode CNEa, may be defined as the first partition pattern PP1a. The first partition pattern PP1a may include the same material as the intermediate layer IML, and the first partition pattern PP1a may be substantially simultaneously formed with the intermediate layer IML through a single process.

The second electrode EL2 may be patterned by or on the tip portion TPa of the connection electrode CNEa, and the portion of the second electrode EL2 may be disposed in the groove GV. The portion of the second electrode EL2, which is separated from the second electrode EL2 by the tip portion TPa of the connection electrode CNEa, may be defined as the second partition pattern PP2a. The second partition pattern PP2a may include the same material as the second electrode EL2, and the second partition pattern PP2a may be substantially simultaneously formed with the second electrode EL2 through a single process. The first partition pattern PP1a and the second partition pattern PP2a may form the dummy patterns DMPa.

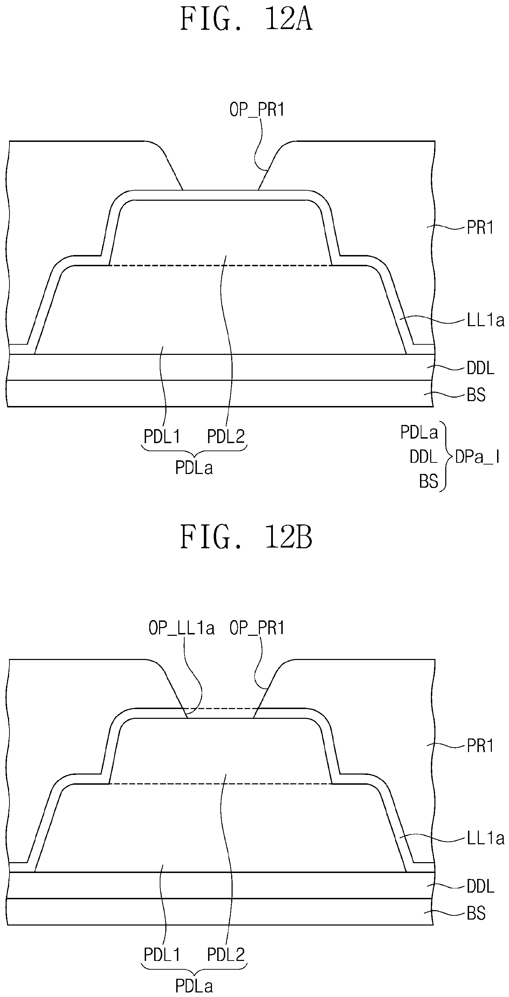

FIGS. 12A to 12F are schematic cross-sectional views illustrating processes of a manufacturing method of the display panel according to an embodiment of the disclosure. In FIGS. 12A to 12F, the same/similar reference numerals denote the same/similar elements in FIGS. 1 to 11C, and thus, detailed descriptions of the same elements will be omitted. The display panel manufactured by the manufacturing method shown in FIGS. 12A to 12F may correspond to the display panel shown in FIG. 8.

Referring to FIG. 12A, the manufacturing method of the display panel includes preparing a preliminary display panel DPa_I and depositing the first connection electrode layer LL1a. The preliminary display panel DPa_I includes the base layer BS, the driving element layer DDL disposed on the base layer BS, and the pixel definition layer PDLa disposed on the driving element layer DDL.

The pixel definition layer PDLa is formed on the driving element layer DDL. A preliminary pixel definition layer may be deposited on the driving element layer DDL and may be selectively patterned through photolithography and etching processes, and thus, the pixel definition layer PDLa including the first pixel definition layer portion PDL1 and the second pixel definition layer portion PDL2 having the shape protruding from the first pixel definition layer portion PDL1 may be formed. The first pixel definition layer portion PDL1 and the second pixel definition layer portion PDL2 may be formed through a single process and may have a single body. A halftone mask may be used in the process of forming the pixel definition layer PDLa, however, the method of forming of the pixel definition layer PDLa should not be limited thereto or thereby. In addition, the light emitting opening OP-PDL (refer to FIG. 5) and the through hole OP-P (refer to FIG. 5) may be defined through the pixel definition layer PDLa.

The first connection electrode layer LL1a is deposited on the preliminary display panel DPa_I. In detail, the first connection electrode layer LL1a may be deposited on the first pixel definition layer portion PDL1 and the second pixel definition layer portion PDL2 of the pixel definition layer PDLa. The depositing of the first connection electrode layer LL1a may be performed by a process of depositing the conductive material. The conductive material used to form the first connection electrode layer LL1a may include the transparent conductive oxide (TCO), such as indium tin oxide (ITO), indium zinc oxide (IZO), indium gallium zinc oxide (IGZO), zinc oxide (ZnO), indium oxide (In₂O₃), or the like, however, the material for the first connection electrode layer LL1a should not be limited thereto or thereby.

The manufacturing method of the display panel may include forming a first photoresist layer PR1. The first photoresist layer PR1 may be formed on the first connection electrode layer LL1a. The first photoresist layer PR1 may be formed by forming a preliminary photoresist layer on the first connection electrode layer LL1a and patterning the preliminary photoresist layer using a photomask. Through the patterning process, the first photoresist layer PR1 through which the first photo opening OP_PR1 is defined may be formed.

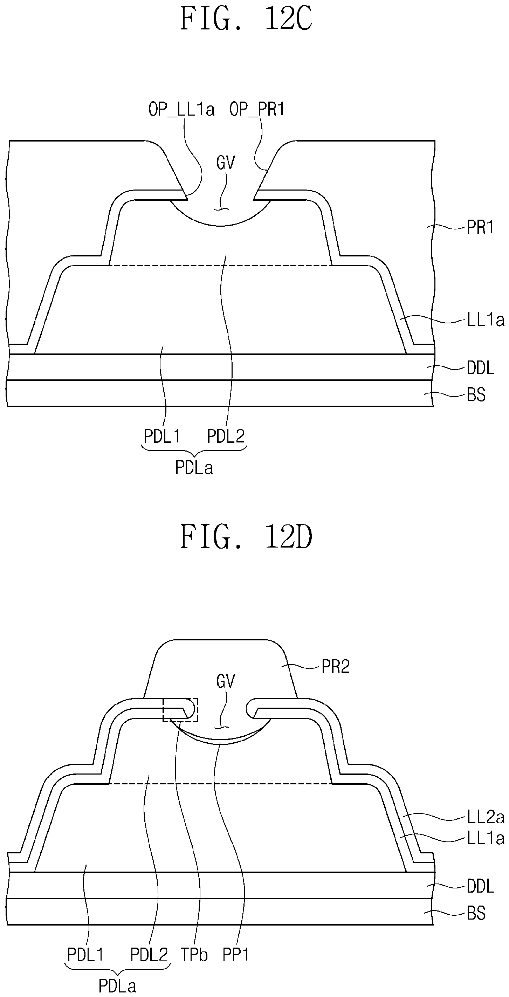

Referring to FIGS. 12B and 12C, the manufacturing method of the display panel includes forming the groove GV of the pixel definition layer PDLa, which overlaps the portion of the first connection electrode layer LL1a.

Referring to FIG. 12B, the forming of the groove GV of the pixel definition layer PDLa includes etching the portion of the first connection electrode layer LL1a. The etching process for the first connection electrode layer LL1a may be a wet etching. The portion of the first connection electrode layer LL1a may be removed by the etching process, and thus, the first opening OP_LL1a may be formed through the first connection electrode layer LL1a. The first opening OP_LL1a may overlap the first photo opening OP_PR1 of the first photoresist layer PR1. The end of the first connection electrode layer LL1a that defines the first opening OP_LL1 may have the tapered shape. As an example, the taper angle between the lower surface of the first connection electrode layer LL1a and the side surface of the first connection electrode layer LL1a may be an acute or right angle, however, the disclosure should not be limited thereto or thereby.

Referring to FIG. 12C, the forming of the groove GV of the pixel definition layer PDLa includes etching the portion of the pixel definition layer PDLa. The etching process for the pixel definition layer PDLa may be a dry etching. The portion of the pixel definition layer PDLa may be removed by the etching process, and thus, the groove GV may be formed in the pixel definition layer PDLa. The groove GV may overlap the first opening OP_LL1a of the first connection electrode layer LL1a and the first photo opening OP_PR1 of the first photoresist layer PR1. The groove GV overlaps the portion of the first connection electrode layer LL1a. That is, the portion of the first connection electrode layer LL1a may protrude from the end of the groove GV to the center of the groove GV.

Referring to FIG. 12D, the manufacturing method of the display panel may include removing the first photoresist layer PR1 (refer to FIG. 12C), depositing the second connection electrode layer LL2a, and forming the tip portion TPb.

The second connection electrode layer LL2a may be deposited on the first connection electrode layer LL1a. The depositing of the second connection electrode layer LL2a may be formed by a process of depositing the conductive material. The conductive material used to form the second connection electrode layer LL2a may include the transparent conductive oxide (TCO), such as indium tin oxide (ITO), indium zinc oxide (IZO), indium gallium zinc oxide (IGZO), zinc oxide (ZnO), indium oxide (In₂O₃), or the like, however, the material for the second connection electrode layer LL2a should not be limited thereto or thereby. The tip portion TPb may be defined by the end of the first connection electrode layer LL1a and the end of the second connection electrode layer LL2a, which covers the end of the first connection electrode layer LL1a.

According to the disclosure, as the second connection electrode layer LL2a is patterned by or on the protruded end of the first connection electrode layer LL1a, the second connection electrode layer LL2a may smoothly surround the side surface S_LL1a of the first connection electrode layer LL1a, and the tip portion TPb of the connection electrode CNEb may have a reverse-tapered shape. In addition, as the pixel definition layer PDLa includes the second pixel definition layer portion PDL2 that protrudes from the first pixel definition layer portion PDL1, the tip portion TPb of the connection electrode CNEb may have the reverse-tapered shape due to the slope of the second pixel definition layer portion PDL2.

The second connection electrode layer LL2a may be patterned by or on the end of the first connection electrode layer LL1a, and the portion of the second connection electrode layer LL2a may be disposed in the groove GV. The portion of the second connection electrode layer LL2a, which is separated from the second connection electrode layer LL2a by the end of the first connection electrode layer LL1a, may be defined as the first partition pattern PP1. The first partition pattern PP1 may include the same material as the second connection electrode layer LL2a, and the first partition pattern PP1 may be substantially simultaneously formed with the second connection electrode layer LL2a through a single process.

The manufacturing method of the display panel may include forming a second photoresist layer PR2. The second photoresist layer PR2 may be formed on the second connection electrode layer LL2a. The second photoresist layer PR2 may be formed by forming a preliminary photoresist layer on the second connection electrode layer LL2a and patterning the preliminary photoresist layer using a photomask. Through the patterning process, the second photoresist layer PR2 that overlaps the groove GV may be formed.

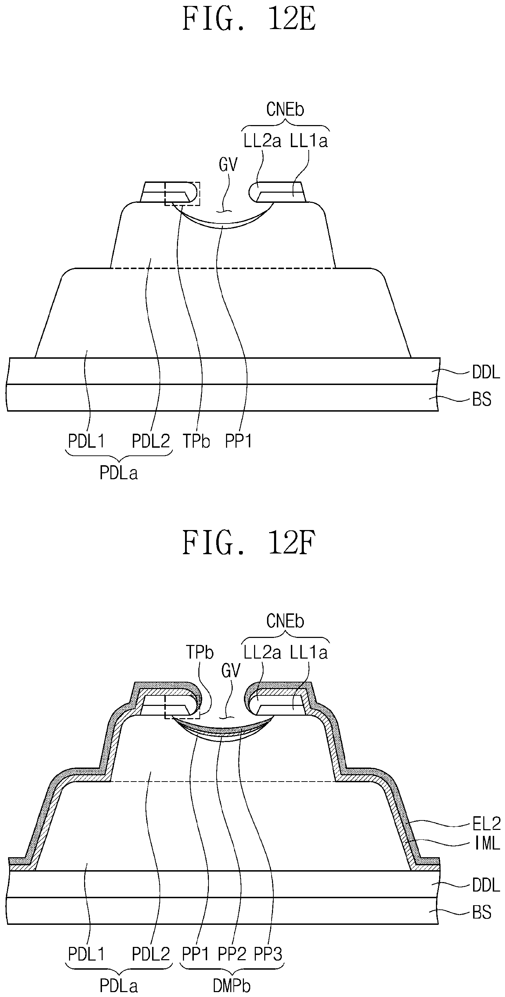

Referring to FIG. 12E, the manufacturing method of the display panel may include etching the first connection electrode layer LL1a and the second connection electrode layer LL2a to form the connection electrode CNEb. The etching process for the first connection electrode layer LL1a and the second connection electrode layer LL2a may be a wet etching process. A portion of the first connection electrode layer LL1a and a portion of the second connection electrode layer LL2a, which do not overlap the second photoresist layer PR2 (refer to FIG. 12D), may be etched and removed. The first connection electrode layer LL1a and the second connection electrode layer LL2a, which remain and overlap the second photoresist layer PR2, may form the connection electrode CNEb. The second photoresist layer PR2 may be removed.

Referring to FIG. 12F, the manufacturing method of the display panel includes forming the intermediate layer IML and the second electrode EL2 (or the cathode) on the connection electrode CNEb and the pixel definition layer PDLa. Each of the forming of the intermediate layer IML and the forming of the second electrode EL2 may be performed by a depositing process.

The intermediate layer IML may be patterned by or on the tip portion TPb of the connection electrode CNEb, and the portion of the intermediate layer IML may be disposed in the groove GV. The portion of the intermediate layer IML, which is separated from the intermediate layer IML by the tip portion TPb of the connection electrode CNEb, may be defined as the second partition pattern PP2. The second partition pattern PP2 may include the same material as the intermediate layer IML, and the second partition pattern PP2 may be substantially simultaneously formed with the intermediate layer IML through a single process.

The second electrode EL2 may be patterned by or on the tip portion TPb of the connection electrode CNEb, and the portion of the second electrode EL2 may be disposed in the groove GV. The portion of the second electrode EL2, which is separated from the second electrode EL2 by the tip portion TPb of the connection electrode CNEb, may be defined as the third partition pattern PP3. The third partition pattern PP3 may include the same material as the second electrode EL2, and the third partition pattern PP3 may be substantially simultaneously formed with the second electrode EL2 through a single process. The first partition pattern PP1, the second partition pattern PP2, and the third partition pattern PP3 may form the dummy patterns DMPb.

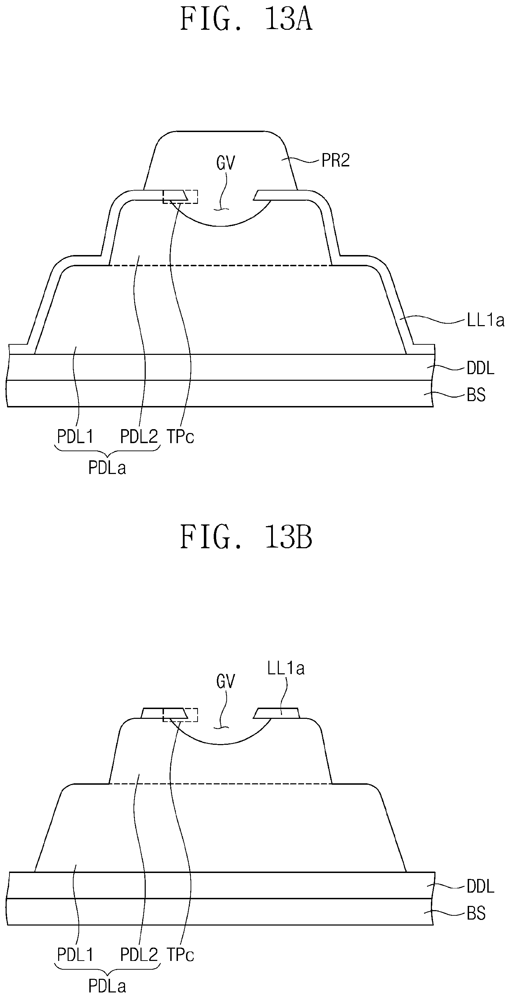

FIGS. 13A to 13C are schematic cross-sectional views illustrating processes of a method of manufacturing the display panel according to an embodiment of the disclosure. In FIGS. 13A to 13C, the same/similar reference numerals denote the same/similar elements in FIGS. 1 to 12F, and thus, detailed descriptions of the same elements will be omitted. The display panel manufactured by the manufacturing method shown in FIGS. 13A to 13C may correspond to the display panel shown in FIG. 9.

The manufacturing method of the display panel includes preparing the preliminary display panel DPa_I (refer to FIG. 12A), depositing the first connection electrode layer LL1a, and forming the groove GV of the pixel definition layer PDLa to overlap a portion of the first connection electrode layer LL1a. The preparing of the preliminary display panel DPa_I (refer to FIG. 12A), the depositing of the first connection electrode layer LL1a, and the forming of the groove GV of the pixel definition layer PDLa, which overlaps the portion of the first connection electrode layer LL1a, may be substantially the same as those of FIGS. 12A to 12C.

Referring to FIG. 13A, the manufacturing method of the display panel may include removing the first photoresist layer PR1 (refer to FIG. 12C), forming the tip portion TPc, and forming the second photoresist layer PR2. The tip portion TPc may be defined by the end of the first connection electrode layer LL1a.

According to the disclosure, as the pixel definition layer PDLa may include the second pixel definition layer portion PDL2 that protrudes from the first pixel definition layer portion PDL1, the tip portion TPc of the connection electrode CNEc may have the reverse-tapered shape by the slope of the second pixel definition layer portion PDL2.

The second photoresist layer PR2 may be formed on the first connection electrode layer LL1a. The second photoresist layer PR2 may be formed by forming a preliminary photoresist layer on the first connection electrode layer LL1a and patterning the preliminary photoresist layer using a photomask. Through the patterning process, the second photoresist layer PR2 that overlaps the groove GV may be formed.

Referring to FIG. 13B, the manufacturing method of the display panel includes etching the first connection electrode layer LL1a to form the connection electrode CNEc. The etching process for the first connection electrode layer LL1a may be a wet etching. The portion of the first connection electrode layer LL1a, which does not overlap the second photoresist layer PR2 (refer to FIG. 13A), may be etched and removed, and the first connection electrode layer LL1a that remains and overlaps the second photoresist layer PR2 may form the connection electrode CNEc. The second photoresist layer PR2 may be removed.

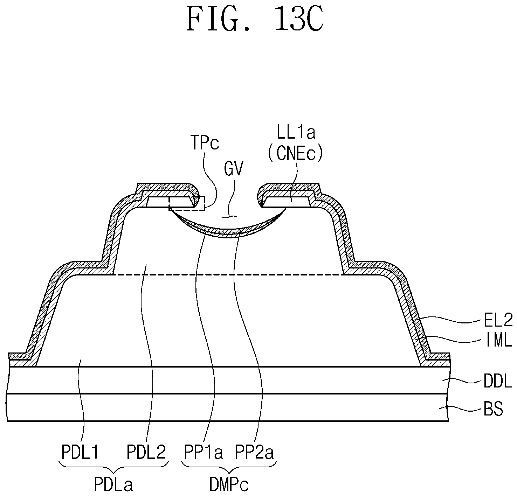

Referring to FIG. 13C, the manufacturing method of the display panel includes forming the intermediate layer IML and the second electrode EL2 (or the cathode) on the connection electrode CNEc and the pixel definition layer PDLa. Each of the forming of the intermediate layer IML and the forming of the second electrode EL2 may be performed by a depositing process.

The intermediate layer IML may be patterned by or on the tip portion TPc of the connection electrode CNEc, and the portion of the intermediate layer IML may be disposed in the groove GV. The portion of the intermediate layer IML, which is separated from the intermediate layer IML by the tip portion TPc of the connection electrode CNEc, may be defined as the first partition pattern PP1a. The first partition pattern PP1a may include the same material as the intermediate layer IML, and the first partition pattern PP1a may be substantially simultaneously formed with the intermediate layer IML through a single process.

The second electrode EL2 may be patterned by or on the tip portion TPc of the connection electrode CNEc, and the portion of the second electrode EL2 may be disposed in the groove GV. The portion of the second electrode EL2, which is separated from the second electrode EL2 by the tip portion TPc of the connection electrode CNEc, may be defined as the second partition pattern PP2a. The second partition pattern PP2a may include the same material as the second electrode EL2, and the second partition pattern PP2a may be substantially simultaneously formed with the second electrode EL2 through a single process. The first partition pattern PP1a and the second partition pattern PP2a may form the dummy patterns DMPc.

Although embodiments of the disclosure have been described, it is understood that the disclosure should not be limited to these embodiments but various changes and modifications can be made by one of ordinary skill in the art within the scope of the disclosure. Therefore, the disclosed subject matter should not be limited to the embodiments described herein.

## Claims

1. A display panel, comprising:
a driving element layer comprising a pixel driving part;
a light emitting element disposed on the driving element layer and comprising:
a first electrode;
an intermediate layer disposed on the first electrode; and
a second electrode disposed on the intermediate layer;
a pixel definition layer disposed on the driving element layer and including a light emitting opening to expose at least a portion of the first electrode and a groove to surround the light emitting opening; and
a connection electrode disposed on the pixel definition layer and electrically connected to the pixel driving part and the second electrode.

2. The display panel of claim 1, wherein the light emitting element includes a plurality of light emitting elements, the pixel driving part includes a plurality of pixel driving parts, the connection electrode includes a plurality of connection electrodes, the plurality of connection electrodes electrically connect the plurality of light emitting elements and the plurality of pixel driving parts, and a gap between the plurality of connection electrodes adjacent to each other overlaps the groove.

3. The display panel of claim 1 or 2, wherein the connection electrode comprises:
a first edge; and
a second edge surrounding the first edge, and the second edge overlaps the groove.

4. The display panel of claim 1, 2, or 3, wherein the second electrode is electrically connected to the connection electrode in an area adjacent to the groove.

5. The display panel of any one of claims 1 to 4, wherein the connection electrode comprises a tip portion that protrudes from an end of the groove, and the connection electrode overlaps the groove of the pixel definition layer in plan view.

6. The display panel of claim 5, wherein the second electrode is electrically connected to the connection electrode at the tip portion.

7. The display panel of claim 5 or 6, wherein a through hole is further defined through the pixel definition layer, and the connection electrode is electrically connected to the pixel driving part through the through hole.

8. The display panel of claim 5, 6 or 7, wherein the connection electrode comprises:
a first connection electrode layer disposed on the pixel definition layer; and
a second connection electrode layer disposed on the first connection electrode layer, and the second connection electrode layer covers the first connection electrode layer, optionally wherein the intermediate layer is disposed on the second connection electrode layer, the second electrode is disposed on the intermediate layer, and the second electrode is electrically connected to the second connection electrode layer at the tip portion.

9. The display panel of claim 8, further comprising:
a first partition pattern;
a second partition pattern; and
a third partition pattern, wherein
the first partition pattern and the second connection electrode layer include a same material,
the second partition pattern and the intermediate layer include a same material,
the third partition pattern and the second electrode include a same material, and
the first, second, and third partition patterns are disposed in the groove, optionally wherein the first partition pattern is electrically connected to the third partition pattern.

10. The display panel of any one of claims 1 to 9, wherein the connection electrode comprises a first connection electrode layer disposed on the pixel definition layer, and the intermediate layer covers the first connection electrode layer, optionally the display panel further comprises:
a first partition pattern; and
a second partition pattern, wherein
the first partition pattern and the intermediate layer include a same material,
the second partition pattern and the second electrode include a same material, and
the first and second partition patterns are disposed in the groove.

11. The display panel of any one of claims 1 to 10, wherein the pixel definition layer comprises:
a first pixel definition layer portion; and
a second pixel definition layer portion disposed on the first pixel definition layer portion,
the first pixel definition layer portion is integral with the second pixel definition layer portion, and
the groove is defined in the second pixel definition layer portion.

12. A method of manufacturing a display panel, comprising:
preparing a preliminary display panel comprising:
a base layer;
a driving element layer disposed on the base layer; and
a pixel definition layer disposed on the driving element layer;
depositing a first connection electrode layer on the preliminary display panel;
etching a portion of the first connection electrode layer and a portion of the pixel definition layer to form a groove overlapping the first connection electrode layer in the pixel definition layer;
etching the first connection electrode layer to form a connection electrode; and
forming an intermediate layer and a cathode on the connection electrode and the pixel definition layer.

13. The method of claim 12, further comprising forming a tip portion at an end of the first connection electrode layer.

14. The method of claim 12, further comprising:
depositing a second connection electrode layer on the first connection electrode layer; and
forming a tip portion at an end of the first connection electrode layer and an end of the second connection electrode layer,
wherein the forming of the connection electrode comprises etching the second connection electrode layer.

15. The method of claim 12, 13 or 14, wherein the pixel definition layer comprises:
a first pixel definition layer portion; and
a second pixel definition layer portion disposed on the first pixel definition layer portion,
the first pixel definition layer portion is integral with the second pixel definition layer portion, and
the groove is defined in the second pixel definition layer portion.
